(19) Europäisches Patentamt
European Patent Office
Office européen des brevets

(11) **EP 3 382 619 A1**

(12) **EUROPÄISCHE PATENTANMELDUNG**

(43) Veröffentlichungstag:
**03.10.2018  Patentblatt 2018/40**

(51) Int Cl.:
*G06Q 10/06* (2012.01)    *G06Q 10/00* (2012.01)

(21) Anmeldenummer: **18165403.9**

(22) Anmeldetag: **03.04.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **30.03.2017   AT 502522017**

(71) Anmelder: **AVL List GmbH**
**8020 Graz (AT)**

(72) Erfinder:
• **Martin, Piffl**
**8010 Graz (AT)**
• **Schüssler, Martin**
**8010 Graz (AT)**

(74) Vertreter: **Wallinger, Michael**
**Wallinger Ricker Schlotter Tostmann**
**Patent- und Rechtsanwälte Partnerschaft mbB**
**Zweibrückenstrasse 5-7**
**80331 München (DE)**

(54) **ROBUSTHEITSANALYSE BEI FAHRZEUGEN**

(57)    Die Erfindung betrifft ein Verfahren und System zur Analyse einer Robustheit einer Vielzahl von Fahrzeugen einer Fahrzeuggattung, welche eine Vielzahl an Komponenten aufweisen, wobei das Verfahren folgende Arbeitsschritte aufweist: Erfassen von Konfigurationen der Vielzahl von Fahrzeugen, welche durch wenigstens eine Eigenschaft wenigstens einer Komponente der Fahrzeuge charakterisiert sind; Bestimmen jeweils eines Werts einer Zielgröße in Bezug auf die Robustheit der Vielzahl von Fahrzeugen mittels eines Transformationsmodells, welches eine Zuordnungsvorschrift zwischen Konfigurationen der Vielzahl von Fahrzeugen und der einen Zielgröße aufweist, wobei das Transformationsmodell auf einer Ausgleichsrechnung bezüglich Simulationergebnissen beruht, welche aus einer Betriebsverhalten-Simulation einer Vielzahl von Fahrzeugen der Fahrzeuggattung mit jeweils verschiedenen Konfigurationen mittels eines Fahrzeugmodells der Fahrzeuggattung resultieren; und Ausgeben der Werte.

Fig. 1

EP 3 382 619 A1

**Beschreibung**

Die Erfindung betrifft ein Verfahren zur Analyse einer Robustheit wenigstens eines Fahrzeugs einer Fahrzeuggattung, welches eine Vielzahl an Komponenten aufweist und ein Verfahren zur Analyse einer Robustheit einer Fahrzeuggattung, deren Fahrzeuge eine Vielzahl an Komponenten aufweisen. Darüber hinaus betrifft die Erfindung entsprechende Systeme zur Analyse der Robustheit.

Die Qualität ist einer der wichtigsten Entscheidungsfaktoren bei der Auswahl zwischen Wettbewerberprodukten. Daher ist das Verstehen der Einflüsse auf die Qualität und das Beeinflussen der Qualität in der richtigen Weise entscheidend für den Geschäftserfolg eines Produkts und damit auch eines Unternehmens.

Zusätzlich zu den sich daraus ergebenden Qualitätsanforderungen auf der Herstellerseite werden auch Qualitätsstandards durch den Gesetzgeber vorgegeben. Beispielsweise müssen Fahrzeughersteller gewährleisten können, dass alle Fahrzeuge eines Fahrzeugtyps, welche von dem Fahrzeughersteller ausgeliefert werden, Emissionswerte einhalten.

Ein weiteres Beispiel für die Qualität ist die Ausfallwahrscheinlichkeit von einzelnen Komponenten bzw. Bauteilen des Fahrzeugs. Diese Ausfallwahrscheinlichkeit hat einen direkten Einfluss auf die Gesamtbetriebskosten (total cost of ownership) eines Fahrzeugs, welche für den Endverbraucher sehr wichtig ist.

Auch diesbezüglich soll die gesamte Fahrzeugflotte eines Fahrzeugtyps einen vorgegebenen Wert nicht überschreiten.

Die Einhaltung einer gleichbleibenden Qualität stellt jedoch eine Herausforderung dar, da jedes Bauteil des Fahrzeugs gewissen Toleranzen unterliegt und jedes Fahrzeug von dem jeweiligen Halter unterschiedlich genutzt wird und dementsprechend auch unterschiedlich altert.

Vor diesem Hintergrund tritt die Robustheit von Fahrzeugen als Gesamtsystem gegenüber Schwankungen immer mehr in den Vordergrund. Solche Schwankungen können einerseits durch Produktionstoleranzen hervorgerufen werden, aber auch durch das Benutzerverhalten und die Alterung der Komponenten. Diese Schwankungen müssen bei der Entwicklung, der Kalibrierung und der Validierung der Fahrzeuge und insbesondere deren Antriebsstrang berücksichtigt werden, um die gewünschte Robustheit des Gesamtsystems zu erreichen. Der klassische Entwicklungsprozess eines Fahrzeugs oder dessen Antriebsstrangs erfüllt die Herausforderungen, welche sich durch die Schwankungen der Fahrzeugflotte ergeben, nur ungenügend: Zur Berücksichtigung der Schwankungen kommen größtenteils Ingenieur-Know-how oder Experimente in Bezug auf den schlechtesten anzunehmenden Fall zum Einsatz.

Beispielsweise wird die Kalibration eines Fahrzeugkonzepts an einem oder wenigen Fahrzeugen oder Antriebssträngen durchgeführt, um die gewünschte Leistung und die gewünschten Emissionseigenschaften zu überprüfen. Die Schwankungen der Fahrzeugflotte werden durch erfahrungsbasierte Entwicklungsziele oder durch Prüfabläufe bei minimalen oder maximalen Bedingungen berücksichtigt. Hierbei werden im Allgemeinen einige Eigenschaften von Komponenten einzeln auf ihre unteren und oberen Grenzen in Bezug auf die Fahrzeugflotte eingestellt. Zum Beispiel kann hierbei der bestmögliche Turbolader oder der schlechtmöglichste Turbolader angenommen werden und das System dann validiert werden. Dieser Minimal/Maximal-Ansatz kann jedoch keine zwei- oder mehrfaktoriellen Interaktionen oder den Einfluss auf die Schwankungen der gesamten Fahrzeugflotte abbilden.

Ein anderes Beispiel ist die Validierung von Emissionswerten eines Fahrzeugtyps. Die Erfüllung der Emissionsgrenzwerte wird bisher jedoch mittels einzelner Fahrzeuge validiert. Bei der Entwicklung wird daher versucht, erfahrungsbasierte Sicherheitsmargen, wie das sogenannte "Entwicklungsziel", zu berücksichtigen. Manchmal wird darüber hinaus zur Ergänzung eine Prüfung des schlechtesten anzunehmenden Falls vorgenommen. Die Orientierung an einer allgemein gültigen Sicherheitsmarge ist jedoch nicht zufriedenstellend, da das jeweils gewählte Fahrzeugkonzept wesentlich die Schwankungen der Fahrzeugflotte auf die sich daraus ergebenden Emissionen beeinflusst. Die gesetzlichen Grenzwerte für Emissionen werden in Zukunft in Bezug auf die gesamte Fahrzeugflotte eines Fahrzeugtyps vorgegeben werden. Diese Vorgaben werden durch das Vorsehen neuer Sicherheitsmargen voraussichtlich nicht mehr erfüllt werden können.

Grundsätzlich können die Schwankungen innerhalb einer Fahrzeugflotte mathematisch durch eine große Anzahl von korrelierten oder nicht korrelierten Zufallsvariablen modelliert werden. Diese Zufallsvariablen werden in Folge zu einem Zufallsvektor zusammengefasst, dessen vieldimensionale Verteilung bei der Entwicklung eines Fahrzeugs oder eines Antriebsstrangs berücksichtigt werden muss. Jede Realisierung bzw. Stichprobe aus dieser vieldimensionalen Verteilung entspricht dann einem einzelnen Fahrzeug oder einem einzelnen Antriebsstrang mit bestimmten Produktionstoleranzen, bestimmten Messtoleranzen und einer bestimmten Alterungshistorie, welches unter bestimmten Bedingungen betrieben wird.

Eine Menge an Realisierungen bzw. Stichproben des Zufallsvektors wird dann als repräsentativ für die zugrundeliegende Verteilung bezeichnet, wenn die empirischen Verteilungseigenschaften, insbesondere die empirischen Quantile, mit den theoretischen Verteilungseigenschaften, insbesondere die theoretischen Quantile, hinreichend genau übereinstimmen. Wenn die theoretische Verteilung nicht bekannt ist, wird eine Menge von Realisierungen als repräsentativ angenommen, wenn eine beliebige Anzahl an zusätzliche Realisierungen die Eigenschaften der empirischen Verteilung nicht signifikant verändern.

Um Robustheit, insbesondere die Aussagekraft, für die gesamte Fahrzeugflotte zu gewährleisten, müssen bei der Entwicklung eines Fahrzeugs daher alle technischen Entscheidungen in Bezug auf eine repräsentative Menge an Realisierungen getroffen werden. Das heißt, eine Fahrzeugkalibrierung ist nur dann robust, wenn diese für die gesamte repräsentative Menge zufriedenstellend ausfällt. In Abhängigkeit der Anzahl an Zufallsvariablen, muss eine repräsentative Menge mehrere Millionen Realisierungen beinhalten.

Daher verursacht eine vollständige Berücksichtigung von Schwankungen in Bezug auf eine Fahrzeugflotte in dem Entwicklungsprozess bisher einen experimentellen Aufwand, welcher nicht in einem vernünftigen Zeitraum bewältigt werden kann.

Der Einsatz von mathematisch berechneten Robustheitsanalysen ist aus verschiedenen technischen Bereichen bekannt. Beispielsweise betrifft die EP 3 038 026 A1 ein System mit einer Kommunikationseinrichtung, eingerichtet, um einen geplanten Flugablauf, welcher Flugdetails in Bezug auf jeden Flug des geplanten Flugzeitplans beinhaltet, und einen aktuellen Flugplan, welcher Flugdetails in Bezug auf jeden Flug des aktuellen Flugzeitplans beinhaltet, zu empfangen, ein Robustheitsanalysemodul, welches ein simulationsbasiertes Modell beinhaltet, um den geplanten Flugzeitplan und den aktuellen Flugzeitplan zu empfangen und dessen Robustheit zu prüfen, einen Speicher, um Programmbefehle zu speichern, und zumindest einen Prozessor, welcher mit dem Speicher gekoppelt ist und mit dem Robustheitsanalysemodul kommuniziert, wobei der zumindest eine Prozessor eingerichtet ist, um Programmanweisungen auszuführen.

Die Druckschrift US 2003/0009317 A1 betrifft das optimale Design von mechanischen Systemen und insbesondere die Nutzung von Modellen und Simulationen während des Designs von mechanischen Systemen, um eine optimale Leistung des mechanischen Systems unter robusten Betriebsbedingungen zu erreichen.

Es ist eine Aufgabe der Erfindung, eine Analyse der Robustheit in Bezug auf eine Vielzahl von Fahrzeugen einer Fahrzeuggattung oder der gesamten Fahrzeuggattung zu ermöglichen. Insbesondere ist es eine Aufgabe der Erfindung, eine simulationsbasierte Robustheitsanalyse für ein Fahrzeug mit einer Vielzahl an Komponenten zu beschleunigen.

Diese Aufgabe wird durch die erfindungsgemäßen Verfahren und die erfindungsgemäßen Systeme gemäß der unabhängigen Ansprüche gelöst. Vorteilhafte Ausgestaltungen werden in den Unteransprüchen beansprucht. Die Lehre der Ansprüche wird ausdrücklich zum Bestandteil der Offenbarung gemacht.

Ein erster Aspekt der Erfindung betrifft ein Verfahren zur Analyse einer Robustheit wenigstens eines Fahrzeugs einer Fahrzeuggattung, welches eine Vielzahl an Komponenten aufweist, folgende Arbeitsschritte aufweisend:

Erfassen von Konfigurationen des wenigstens einen Fahrzeugs, welche wenigstens eine Eigenschaft wenigstens einer Komponente des Fahrzeugs charakterisieren;

Bestimmen eines Werts einer Zielgröße in Bezug auf die Robustheit des wenigstens einen Fahrzeugs mittels eines Transformationsmodells, welches eine Zuordnungsvorschrift zu den Konfigurationen des wenigstens einen Fahrzeugs und der Zielgröße aufweist, wobei das Transformationsmodell auf einer Ausgleichsrechnung bezüglich Simulationsergebnissen beruht, welche auf einer Betriebsverhalten-Simulation, insbesondere einer zeitaufgelösten Zyklussimulation, einer Vielzahl von Fahrzeugen der Fahrzeuggattung mit jeweils verschiedenen Konfigurationen mittels eines Fahrzeugmodells der Fahrzeuggattung resultieren; und

Ausgeben des Werts.

Ein zweiter Aspekt der Erfindung betrifft ein Verfahren zur Analyse einer Robustheit einer Fahrzeuggattung, deren Fahrzeuge eine Vielzahl an Komponenten aufweisen, folgende Arbeitsschritte aufweisend:

Simulieren von Betriebsverhalten einer Vielzahl von Fahrzeugen der Fahrzeuggattung mit jeweils verschiedener Konfiguration mittels eines Fahrzeugmodells der Fahrzeuggattung, wobei jede Konfiguration wenigstens eine Eigenschaft einer Komponente eines Fahrzeugs der Fahrzeuggattung charakterisiert;

Durchführen einer Ausgleichsrechnung auf der Grundlage des simulierten Betriebsverhaltens der Vielzahl von Fahrzeugen; und

Anwenden eines Transformationsmodells auf der Grundlage einer Ausgleichsrechnung, wobei das Transformationsmodell eine Zuordnungsvorschrift zwischen Konfiguration und wenigstens einer Zielgröße aufweist, wobei das Transformationsmodell eingerichtet ist, auf der Grundlage von Konfigurationen der Fahrzeuggattung einen Wert einer Zielgröße in Bezug auf die Robustheit der Fahrzeuggattung auszugeben.

Ein dritter Aspekt der Erfindung betrifft ein computer-gestütztes Verfahren zum Trainieren eines Transformationsmodells (TM), insbesondere eines künstlichen neuronalen Netzes (KNN), zur Analyse einer Robustheit einer Fahrzeuggattung, deren Fahrzeuge eine Vielzahl an Komponenten aufweisen, folgende Arbeitsschritte aufweisend:

Erfassen von Konfigurationen einer Vielzahl von Fahrzeugen der Fahrzeuggattung, welche jeweils durch wenigstens eine Eigenschaft wenigstens einer Komponente des Fahrzeugs charakterisiert sind;

Simulieren von Betriebsverhalten der Vielzahl von Fahrzeugen mit jeweils verschiedener Konfiguration mittels eines Fahrzeugmodells (FM) der Fahrzeuggattung, wobei jede Konfiguration wenigstens eine Eigenschaft einer Komponente wenigstens eines Fahrzeugs der Fahrzeuggattung charakterisiert; und

Einlesen der Konfigurationen und der Ergebnisse des simulierten Betriebsverhaltens in eine Ausgleichsrechnung, welche die Grundlage für das Transformationsmodell (TM) bildet.

Eine Ausgleichsrechnung im Sinne der Erfindung ist vorzugsweise ein Regressionsverfahren oder ein Mustererkennungsverfahren oder/und eine Kombination aus beidem im Sinne der statistischen Lehre.

Ein Transformationsmodell im Sinne der Erfindung stellt vorzugsweise einen Zusammenhang zwischen den Konfigurationen des einzelnen Fahrzeugs, der Gruppe aus Fahrzeugen oder der Fahrzeuggattung und einer Zielgröße oder einer Gruppe aus Zielgrößen her. Vorzugsweise ist das Transformationsmodell nicht zeitaufgelöst. Weiter vorzugsweise beruht das Transformationsmodell selbst beruht jedoch vorzugsweise auf einer zeitaufgelösten Simulation des Betriebs einer Vielzahl von Fahrzeugen. Vorzugsweise ist ein Transformationsmodell ein Metamodell.

Eine Betriebsverhalten-Simulation im Sinne der Erfindung ist vorzugsweise eine zeitaufgelöste Simulation des Betriebsverhaltens eines Fahrzeugs, Antriebsstrangs oder Motor. Vorzugsweise handelt es sich um eine Zyklussimulation. Dabei wird vorzugsweise ein bestimmter Fahrzyklus oder eine für eine Zyklen-Verteilung repräsentative Auswahl an Fahrzyklen des Fahrzeugs der Fahrzeuggattung herangezogen. Das Betriebsverhalten umfasst vorzugsweise wenigstens eine der Größen Drehzahl, Drehmoment oder Fahrpedalstellung. Zusätzlich oder alternativ können die Größen Geschwindigkeit des Fahrzeugs und/oder Gangwahl verwendet werden.

Eine Zielgröße im Sinne der Erfindung ist vorzugsweise eine zu analysierende Größe, die vorzugsweise von der Konfiguration und dem Betriebsverhalten abhängig ist.

Robustheit im Sinne der Erfindung ist vorzugsweise die Fähigkeit einer Vielzahl von Fahrzeugen einer Fahrzeuggattung, welche insbesondere eine sogenannte Fahrzeugflotte darstellt, zuverlässig zu funktionieren. Vorzugsweise ist eine Vielzahl von Fahrzeugen einer Fahrzeuggattung dann robust, wenn die Werte wenigstens einer Zielgröße für die gesamte Vielzahl von Fahrzeugen unter Berücksichtigung von Schwankungen von den verschiedenen Faktoren, insbesondere unkontrollierbaren Störfaktoren, innerhalb von vordefinierten Bereichen liegen. Beispiele für solche Faktoren sind Produktionstoleranzen, Messtoleranzen, unterschiedliche Nutzung, Alterung, Umgebungsbedingungen, etc. Vorzugsweise kann Robustheit auch die Fähigkeit eines Fahrzeugs und/oder dessen Komponenten sein, unter Berücksichtigung von Schwankungen von verschiedenen Faktoren zuverlässig zu funktionieren. Das Fahrzeug kann diesbezüglich in verschiedenen Konfigurationen ausgebildet sein, wobei die einzelnen Konfigurationen sich insbesondere durch unterschiedliche Nutzung, Alterung und/oder Umgebungsbedingungen während der Nutzung unterscheiden.

Eine Fahrzeuggattung im Sinne der Erfindung ist vorzugsweise eine Vielzahl von Fahrzeugen, welche wenigstens im Wesentlichen Komponenten derselben Bauart aufweisen. Vorzugsweise sind wenigstens jene Komponenten der Fahrzeuggattung von derselben Bauart, für welche eine Robustheitsanalyse durchgeführt werden soll. Eine Fahrzeuggattung kann insbesondere die gesamte Fahrzeugflotte eines Fahrzeugtyps eines Herstellers sein.

Ein Versuch im Sinne der Erfindung ist vorzugsweise ein Testlauf einer realen oder virtuellen technischen Einrichtung mit einer spezifischen Konfiguration und einem bestimmten Betriebsverhalten über eine festgelegte Zeit. Vorzugsweise wird der Versuch mittels einer Betriebsverhalten-Simulation durchgeführt.

Eine Komponente im Sinne der Erfindung ist vorzugsweise ein Bauteil oder eine Baugruppe eines Fahrzeugs.

Ein Fahrzeug im Sinne der Erfindung ist vorzugsweise jede Art von Land-, Wasser-, Luft- oder Raumfahrzeug, insbesondere ein Kraftfahrzeug.

Erfassen im Sinne der Erfindung ist vorzugsweise ein Einlesen von Informationen zur Weiterverarbeitung. Vorzugsweise wird die Information dabei, insbesondere über eine Datenschnittstelle, dem erfindungsgemäßen Verfahren oder dem erfindungsgemäßen System bereitgestellt.

Ausgeben im Sinne der Erfindung ist vorzugsweise ein Bereitstellen. Vorzugsweise erfolgt das Bereitstellen über eine Datenschnittstelle. Insbesondere ist aber auch möglich, eine Information über eine Benutzerschnittstelle, beispielsweise einen Bildschirm, auszugeben.

Eine Konfiguration im Sinne der Erfindung entspricht vorzugsweise einem Punkt in einem Versuchsraum, welcher durch jene Eigenschaften definiert wird, die die Robustheit der Fahrzeuggattung bestimmen. Eigenschaften im Sinne der Erfindung sind vorzugsweise eine Mess- und/oder Produktionstoleranz wenigstens einer Komponente eines Fahrzeugs und/oder des Fahrzeugs, eine Alterung wenigstens einer Komponente eines Fahrzeugs und/oder des Fahrzeugs, eine Nutzung wenigstens einer Komponente eines Fahrzeugs und/oder des Fahrzeugs, insbesondere mittels charakteristischer Fahrzyklen, und/oder wenigstens eine Umgebungsbedingung, unter welcher eine Nutzung erfolgt.

Eine repräsentative Auswahl im Sinne der Erfindung ist vorzugsweise eine Auswahl von Realisierungen oder eine Stichprobe, auf deren Grundlage verallgemeinernde Aussagen über eine wesentlich größere Menge, eine sogenannte Grundgesamtheit, getroffen werden können. Eine Menge an zufällig ausgewählten Realisierungen oder eine zufällig ausgewählte Stichprobe wird insbesondere dann als repräsentativ für die zugrundeliegende Verteilung bezeichnet, wenn die empirischen Verteilungseigenschaften, insbesondere die empirischen Quantile, mit den theoretischen Verteilungseigenschaften, insbesondere die theoretischen Quantile, hinreichend genau übereinstimmen, insbesondere die punktweise Differenz zwischen empirischen Quantilen und theoretischen Quantilen in einem vordefinierten Fehlerband liegen. Wenn die theoretische Verteilung nicht bekannt ist, wird eine Menge von Realisierungen oder eine Stichprobe insbesondere als repräsentativ angenommen, wenn eine beliebige Anzahl an zusätzlichen Realisierungen die Eigenschaften der empirischen Verteilung nicht signifikant verändern.

Eine Gruppe von Fahrzeugen einer Fahrzeuggattung im Sinne der Erfindung besteht vorzugsweise aus mehreren Fahrzeugen der Fahrzeuggattung, bei denen wenigstens eine Eigenschaft identisch ausgeprägt ist, welche aber in Bezug auf wenigstens eine andere Eigenschaft unterschiedlich sind. Dies können insbesondere identische Fahrzeuge sein, welche eine unterschiedliche Nutzung erfahren haben und/oder unterschiedlichen Umweltbedingungen unterworfen waren. Alternativ können dies Fahrzeuge mit unterschiedlichen Mess- und/oder Produktionstoleranzen wenigstens einer Komponente eines Fahrzeugs und/oder des Fahrzeugs oder auch mit unterschiedliche Alterungen wenigstens einer Komponente eines Fahrzeugs und/oder des Fahrzeugs sein, welche identische Nutzungen erfahren haben und/oder identischen Umweltbedingungen unterworfen waren.

Eine repräsentative Auswahl von Fahrzeugen aus einer solchen Gruppe ist somit vorzugsweise eine Auswahl von Realisierungen oder eine Stichprobe aus dieser Gruppe, auf deren Grundlage verallgemeinernde Aussagen über die gesamte Gruppe getroffen werden können.

Eine Betriebsverhalten-Simulation oder Simulation von Betriebsverhalten eines Fahrzeugs im Sinne der Erfindung ist vorzugsweise die Simulation des Betreibens des Fahrzeugs in einem, insbesondere vordefinierten, Fahrzyklus. Hierfür kommen beispielsweise der NEFZ oder auch ein RDE-Zyklus in Frage. Der Erfindung liegt insbesondere die Erkenntnis zugrunde, dass sich zwischen der Veränderung von Schwankungsbreiten von Eigenschaften von Fahrzeugen, insbesondere deren Komponenten, und Zielgrößen in Bezug auf die Robustheit ein funktionaler Zusammenhang finden lässt. Die Erfindung beruht dabei auf dem Ansatz, Auswertungen von Ausfallstatistiken einer Fahrzeugflotte im Feld, Versuche auf einem (Dauerlauf-)Prüfstand oder zeitaufgelöste Versuche auf einem virtuellen Prüfstand zur Robustheit durch ein empirisches Modell zu ersetzen.

Der Einsatz der Erfindung bei der Robustheitsanalyse ermöglicht es, die Robustheit eines Fahrzeuges, einer Gruppe von Fahrzeugen oder einer ganzen Fahrzeuggattung zu analysieren, ohne die Komponenten des Fahrzeugs oder das Fahrzeug selbst als physischen Prüfling zur Verfügung zu haben. Die gesamte Robustheitsanalyse kann rechnerisch mittels des Transformationsmodells durchgeführt werden.

Gegenüber bestehenden Simulationsverfahren kann dabei die Anzahl an zeitaufgelösten Simulationen von einzelnen Realisierungen bzw. Stichproben des Betriebsverhaltens wesentlich reduziert werden.

Zur vollständigen Robustheitsanalyse eines zum Anmeldezeitpunkt gängigen Antriebsstrangs müssen durch Einsatz der Erfindung anstatt einer repräsentativen Auswahl an Konfigurationen aus dem Versuchsraum in einer Größenordnung von $10^6$ lediglich wenige hunderte zeitaufgelöste Simulationen vorgenommen werden. Die Ergebnisse der übrigen Konfigurationen der repräsentativen Auswahl können dagegen mittels des Transformationsmodells vorhergesagt werden. Ist das Transformationsmodell für einen bestimmten Versuchsraum bekannt, so können sogar alle Konfigurationen von Verteilungen innerhalb der ursprünglichen Schwankungsbreiten durch das Transformationsmodell vorausgesagt werden, ohne zusätzliche zeitaufgelöste Simulationen durchführen zu müssen.

Erfindungsgemäß wird daher eine wesentliche Beschleunigung der rechnergestützten Simulationsanalyse erreicht. Simulationszeiten von mehreren Monaten können auf diese Weise auf wenige Stunden oder Minuten verkürzt werden. Musste bisher oftmals auf eine rechnergestützte Robustheitsanalyse in einem frühen Entwicklungsstadium eines Fahrzeugs oder einer Fahrzeugkomponente, an welcher noch kein Prototyp vorlag, verzichtet werden, kann die Robustheitsanalyse mit dem erfindungsgemäßen Verfahren bereits bei Vorliegen eines Fahrzeugmodells für eine Fahrzeuggattung durchgeführt werden.

Des Weiteren ermöglicht die Erfindung eine Ursachenanalyse in Bezug auf die Robustheit der Fahrzeuggattung. So können beispielsweise die Schwankungsbreiten der einzelnen Eigenschaften der analysierten Konfigurationen und damit die jeweiligen Verteilungen kontinuierlich verändert werden und die entsprechenden Auswirkungen auf die Robustheit unmittelbar beobachtet werden. Auf diese Weise können Bereiche des Versuchsraums, welche für die Robustheit von hoher Relevanz sind, einfach identifiziert und untersucht werden.

Ein weiterer Vorteil der Erfindung besteht vorzugsweise darin, dass Konfigurationen einer Vielzahl von Fahrzeugen der Fahrzeuggattung erfasst werden und jeweils ein Wert einer oder mehrerer Zielgrößen pro Fahrzeug bestimmt werden. Hierdurch bilden die ausgegebenen Werte eine Verteilung, welche Auskunft über ein Flottenverhalten der durch die Vielzahl an Fahrzeugen gebildete Fahrzeugflotte in Bezug auf die Zielgröße oder Zielgrößen gibt. Dieses Verhalten hängt dabei insbesondere von den Verteilungen ab, welchen die einzelnen Eigenschaften der Konfigurationen unterliegen.

In einer weiteren vorteilhaften Ausgestaltung nach einem der vorhergehenden Ansprüche, des Weiteren folgenden Arbeitsschritt aufweisend:
Berechnen einer Wahrscheinlichkeit eines Werts oder einer Wahrscheinlichkeitsverteilung einer Zielgröße oder einer Verteilungsfunktion der Zielgröße auf der Grundlage der bestimmten Werte.

In einer weiteren vorteilhaften Ausgestaltung weist ein erfindungsgemäßes Verfahren des Weiteren folgenden Arbeitsschritt auf:

Erzeugen einer repräsentativen Auswahl einer Gruppe von Fahrzeugen der Fahrzeuggattung oder einer repräsentativen Auswahl von Fahrzeugen der gesamten Fahrzeuggattung, deren Konfigurationen erfasst werden; oder

Erzeugen einer repräsentativen Auswahl von Konfigurationen der Vielzahl von Fahrzeugen.

Durch eine Berücksichtigung einer repräsentativen Auswahl aus dem Versuchsraum kann gewährleistet werden, dass die sich ergebenden Werte der Zielgröße in Bezug auf die Robustheit für die gesamte betrachtete Verteilung repräsentativ sind.

In einer weiteren vorteilhaften Ausgestaltung eines erfindungsgemäßen Verfahrens werden die Grundkonfigurationen durch eine Nutzung der wenigstens einen Komponente und/oder des wenigstens einen Fahrzeugs, insbesondere durch charakteristische Fahrzyklen und/oder durch wenigstens eine Umgebungsbedingung, unter welcher eine Nutzung erfolgt, als weitere Eigenschaften charakterisiert.

Durch diese Ausgestaltung kann einerseits die gesamte Fahrzeuggattung auf den Einfluss von äußeren Umgebungsbedingungen auf die Komponenten untersucht werden, andererseits kann auch ein einzelnes Fahrzeug mit deterministisch festgelegten Toleranzen auf den Einfluss äußerer Bedingungen untersucht werden.

In einer weiteren vorteilhaften Ausgestaltung eines erfindungsgemäßen Verfahrens ist die Nutzung durch Lastmerkmale und Dynamikmerkmale gekennzeichnet.

Lastmerkmale und Dynamikmerkmale haben sich für die Differenzierung von verschiedenen charakteristischen Fahrzyklen als besonders geeignet herausgestellt.

In einer weiteren vorteilhaften Ausgestaltung eines erfindungsgemäßen Verfahrens weist dieses des Weiteren die folgenden Arbeitsschritte auf:
Erzeugen einer repräsentativen Auswahl aus möglichen Konfigurationen der weiteren Eigenschaften, wobei diese Konfigurationen erfasst werden.

Vorzugsweise kann die repräsentative Auswahl aus den möglichen Konfigurationen der weiteren Eigenschaften mit der repräsentativen Auswahl an Fahrzeugen aus der Fahrzeuggattung kombiniert werden, so dass eine repräsentative Auswahl in Bezug auf die Verteilung von den Eigenschaften der Komponenten des Fahrzeugs und der weiteren Eigenschaften entsteht.

In einer weiteren vorteilhaften Ausgestaltung eines erfindungsgemäßen Verfahrens beruht die repräsentative Auswahl auf einem Zufallsexperiment oder mehreren Zufallsexperimenten, insbesondere einer Monte-Carlo-Simulation.

In einer weiteren vorteilhaften Ausgestaltung eines erfindungsgemäßen Verfahrens wird für eine Konfiguration eine Vielzahl an Eigenschaften einer Vielzahl an Komponenten erfasst und das Transformationsmodell ist geeignet, aus diesen Konfigurationen einen oder wenige Zielgrößenwerte in Bezug auf das wenigstens eine Fahrzeug zu bestimmen.

Erfindungsgemäß lässt sich daher eine multidimensionale Verteilung auf eine eindimensionale Zielgröße abbilden.

In einer weiteren vorteilhaften Ausgestaltung eines erfindungsgemäßen Verfahrens beruht die Simulation oder das Simulieren auf einer Auswahl an Konfigurationen, welche mittels statistischer Versuchsplanung innerhalb von Grenzen einer ersten Verteilung aller möglichen Konfigurationen ausgewählt ist.

Hierdurch kann gewährleistet werden, dass das Transformationsmodell den gesamten Versuchsraum, in welchem die erste Verteilung aufgespannt ist, abbildet.

In einer weiteren vorteilhaften Ausgestaltung eines erfindungsgemäßen Verfahrens ist die repräsentative Auswahl innerhalb von Grenzen einer zweiten Verteilung ausgewählt. Das Transformationsmodell eignet sich insbesondere zur Abbildung einer beliebigen Verteilung, bei welcher die Schwankungsbereiche der Eigenschaften innerhalb der Schwankungsbereiche liegen, die bei der ersten Verteilung vorgegeben waren.

In einer weiteren vorteilhaften Ausgestaltung eines erfindungsgemäßen Verfahrens ist die Dimension der ersten und/oder der zweiten Verteilung gleich der Anzahl der Eigenschaften, welche in den Konfigurationen berücksichtigt ist.

In einer weiteren vorteilhaften Ausgestaltung eines erfindungsgemäßen Verfahrens ist die Zielgröße wenigstens eine aus der folgenden Gruppe an Zielgrößen: Emissionen des Fahrzeugs, insbesondere Schadstoffemissionen im Feld, eine Fehlermeldung und/oder ein Fehlereintrag im Steuergerät, eine Reparaturmeldung, eine Warnleuchte, eine Sicherheitsmeldung, in Bezug auf eine Fahrzeugkomponente, insbesondere einer Fahrwerkskomponente, eine Antriebsstrangkomponente, ein Fahrerassistenzsystem oder einen Servoantrieb. Des Weiteren kann eine Zielgröße auch ein Schadensereignis und/oder ein Lastkollektiv, insbesondere eine oder mehrere potentielle schädigende Eingangsgrößen für eine Komponente und/oder deren Subkomponenten, sein. Auch, eine Adaption von Mess- und/oder Produktionstoleranzen in einer Lernphase, oder die finale Beladung eines Katalysators am Ende einer Vorkonditionierungsphase kann eine Zielgröße sein.

In einer weiteren vorteilhaften Ausgestaltung eines erfindungsgemäßen Verfahrens ist die wenigstens eine Eigenschaft wenigstens einer Komponente des Fahrzeugs aus der folgenden Gruppe ausgewählt: Messtoleranzen der Komponente, Produktionstoleranzen der Komponente, eine Alterung der wenigstens einen Komponente und/oder des wenigstens einen Fahrzeugs, eine Nutzung wenigstens einer Komponente und/oder des wenigstens einen Fahrzeugs, insbesondere mittels charakteristischer Fahrzyklen, und/oder wenigstens eine Umgebungsbedingung, unter welcher eine Nutzung erfolgt.

In einer weiteren vorteilhaften Ausgestaltung eines erfindungsgemäßen Verfahrens ist die wenigstens eine Eigenschaft durch eine parametrische/nicht-parametrische Wahrscheinlichkeitsverteilung angegeben. Insbesondere sind die Mess- und Produktionstoleranzen als parametrische Verteilung angegeben und die Nutzung ist als nicht-parametrische Wahrscheinlichkeitsverteilung angegeben.

Die im Vorhergehenden in Bezug auf erfindungsgemäße Verfahren beschriebenen Merkmale und Vorteile gelten entsprechend auch für erfindungsgemäße Systeme, erfindungsgemäße Computerprogramme und ein erfindungsgemäße Computer-lesbare Medien entsprechend und umgekehrt.

Ein vierter Aspekt der Erfindung betrifft ein System zur Analyse einer Robustheit wenigstens eines Fahrzeugs einer Fahrzeuggattung, welches eine Vielzahl an Komponenten aufweist, folgende Arbeitsschritte aufweisend:

Mittel zum Erfassen von Konfigurationen des wenigstens einen Fahrzeugs, welche durch wenigstens eine Eigenschaft wenigstens einer Komponente des Fahrzeugs charakterisiert sind;
Mittel zum Bestimmen eines Werts einer Zielgröße in Bezug auf die Robustheit des wenigstens einen Fahrzeugs mittels eines Transformationsmodells, welches eine Zuordnungsvorschrift zwischen Konfigurationen des wenigstens einen Fahrzeugs und der einen Zielgröße aufweist, wobei das Transformationsmodell auf einer Regression bezüglich Simulationergebnissen beruht, welche aus einer Betriebsverhalten-Simulation einer Vielzahl von Fahrzeugen der Fahrzeuggattung mit jeweils verschiedenen Konfigurationen mittels eines Fahrzeugmodells der Fahrzeuggattung resultieren; und
eine Schnittstelle zum Ausgeben des Werts.

Ein fünfter Aspekt der Erfindung betrifft ein System zur Analyse einer Robustheit eines Fahrzeugs einer Fahrzeuggattung, welches eine Vielzahl an Komponenten aufweist, folgende Arbeitsschritte aufweisend:

Mittel zum Erfassen von Konfigurationen einer Vielzahl von Fahrzeugen der Fahrzeuggattung, welche jeweils durch wenigstens eine Eigenschaft wenigstens einer Komponente des Fahrzeugs charakterisiert sind;
Mittel zum Simulieren von Betriebsverhalten der Vielzahl von Fahrzeugen mit jeweils verschiedener Konfiguration mittels eines Fahrzeugmodells (FM) der Fahrzeuggattung, wobei jede Konfiguration wenigstens eine Eigenschaft einer Komponente wenigstens eines Fahrzeugs der Fahrzeuggattung charakterisiert; Mittel zum Durchführen einer Regression auf der Grundlage des simulierten Betriebsverhaltens der Vielzahl von Fahrzeugen; und
Mittel zum Anwenden eines Transformationsmodells auf der Grundlage der Regression, wobei das Transformationsmodell eine Zuordnungsvorschrift zwischen Konfigurationen und wenigstens eine Zielgröße umfasst, wobei das Transformationsmodell eingerichtet ist, auf der Grundlage von Konfigurationen der Fahrzeuggattung einen Wert einer Zielgröße in Bezug auf die Robustheit der Fahrzeuggattung auszugeben.

Ein Mittel im Sinne der vorliegenden Erfindung kann hard- und/oder softwaretechnisch ausgebildet sein, insbesondere eine, vorzugsweise mit einem Speicher- und/oder Bussystem daten- bzw. signalverbundene, insbesondere digitale, Verarbeitungs-, insbesondere Mikroprozessor-Einheit (CPU) und/oder ein oder mehrere Programme oder Programm-Module aufweisen. Die CPU kann dazu ausgebildet sein, Befehle, die als ein in einem Speichersystem abgelegtes Programm implementiert sind, abzuarbeiten, Eingangssignale von einem Datenbus zu erfassen und/oder Ausgangssignale an einen Datenbus zu geben. Ein Speichersystem kann ein oder mehrere, insbesondere verschiedene, Speichermedien, insbesondere optische, magnetische, Festkörper- und/oder andere nicht-flüchtige Medien, aufweisen. Das Programm kann derart beschaffen sein, dass es die hier beschriebenen Verfahren verkörpert bzw. auszuführen imstande ist, dass die CPU die Schritte solcher Verfahren ausführen kann und damit insbesondere einen Wert einer Zielgröße in Bezug auf die Robustheit wenigstens eines Fahrzeugs einer Fahrzeuggattung bestimmen kann.

Weitere Merkmale und Vorteile ergeben sich aus der nachfolgenden Beschreibung der Ausführungsbeispiele in Bezug auf die Figuren. Es zeigen wenigstens teilweise schematisch:

Fig. 1    ein Flussdiagramm eines erfindungsgemäßen Verfahrens gemäß dem ersten Aspekt der Erfindung;

Fig. 2    ein Flussdiagramm in Bezug auf eine Erstellung von verschiedenen Sätzen von Stichproben oder Realisierungen aus einer Gesamtver-

teiling;

Fig. 3 eine Darstellung zur Veranschaulichung einer Herleitung einer Randverteilung aus nichtlinearen Messtoleranzen eines $NO_x$ Sensors;

Fig. 4 eine Darstellung einer Randverteilung in Bezug auf eine Nutzung einer Fahrzeuggattung;

Fig. 5 eine Darstellung einer Randverteilung in Bezug auf Umweltbedingungen bei einer Nutzung von Fahrzeugen;

Fig. 6 ein Flussdiagramm zur Veranschaulichung eines erfindungsgemäßen Verfahrens gemäß dem zweiten Aspekt der Erfindung;

Fig. 7 eine grafische Darstellung eines möglichen Ergebnisses der erfindungsgemäßen Verfahren;

Fig. 8 eine weitere grafische Darstellung eines möglichen Ergebnisses der erfindungsgemäßen Verfahren; und

Fig. 9 eine weitere grafische Darstellung eines möglichen Ergebnisses der erfindungsgemäßen Verfahren.

Im Folgenden werden die erfindungsgemäßen Verfahren im Gesamtzusammenhang einer Bestimmung einer Robustheit dargestellt. Die Bestimmung der Robustheit einer Fahrzeuggattung wird dabei zur Veranschaulichung in sieben Arbeitsschritte gegliedert. Der Fachmann weiß jedoch, dass die beschriebene Vorgehensweise auch in anderer Weise gegliedert werden könnte.

In einem ersten Arbeitsschritt werden Einkünfte über Arbeitsannahmen getroffen. Hierzu gehören vorzugsweise:

- Definition der Ziele der Analyse der Robustheit (zum Beispiel CoP, ISC, OBD, Haltbarkeitsstudien vorzugsweise mit Parameteroptimierung kombiniert)
- Festlegen der Simulationsplattform für eine Betriebsverhalten-Simulation (z.B. HiL, SiL, ETB, CTB, ...)
- Festlegen der Zielgrößen (zum Beispiel Schadstoffe, Fehlereinträge, ...), der Testzyklen (z WHTC-, WHSC, RDE, ...) und der veränderlichen Parameter
- Festlegen der Motor- und/oder EAS Präkonditionierungsmaßnahmen (z.B. Aufwärmphasen, NH3 Beladung, ...)
- Festlegen der ECU-Initialisierung (zum Beispiel Lernphasen, Anpassung Aktivität, etc ...)
- Modellierung von Produktionstoleranzen durch:

  ◦ Anwendung einer Normalverteilung $N$ ($\mu$, $\sigma$) Modellierung Hardware ($\sigma = tol / 4$), Sensor- und Aktor-Toleranzen ($\sigma = tol / 2$ oder $\sigma = tol / 3$)
  ◦ Anwendung einer Beta-Verteilung bei schiefem Toleranzverhalten

- Modellierung einer Nutzungsvariabilität durch:

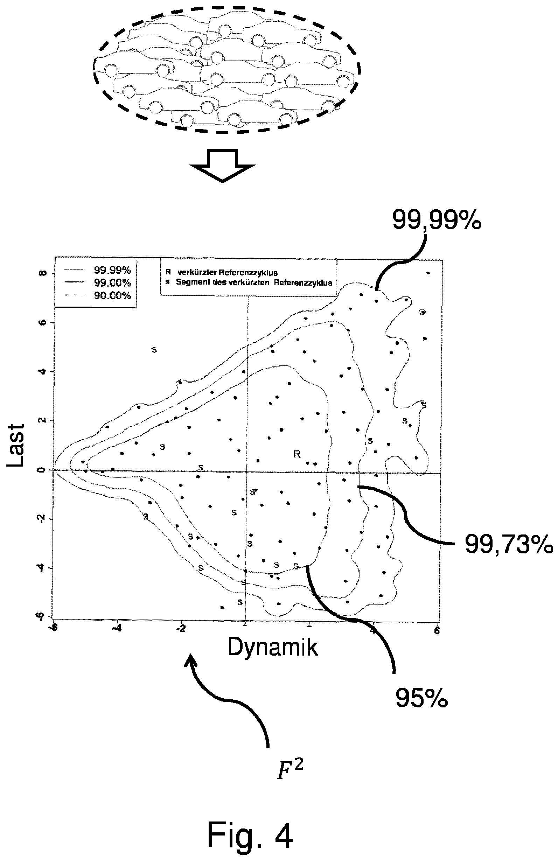

  ◦ Anwendung eines nicht-parametrischer Gauß'schen Modellierkern-Ansatzes, um korrelierte Umweltdaten (Temperatur, Druck und Luftfeuchtigkeit) zu modellieren
  ◦ Nutzungsmodellierung durch einen oder mehrere vorgegebene Zyklen oder durch eine vorhandene Nutzungsverteilung in Abhängigkeit von Last und Dynamik. Ein Beispiel für eine solche Nutzungsverteilung ist in Fig. 4 dargestellt. Hierbei kommt vorzugsweise ein sogenanntes "Depth-Outlyingness-Quantile-Rank Paradigm" zum Einsatz, um aus dieser Verteilung Realisierungen bzw. Stichproben auszuwählen)

- Festlegen, wie eine Alterung der Komponenten in die Modellierung einzubeziehen ist.

  ◦ Alternative 1: Die Alterung wird als eine unabhängige Eingangsgröße der Analyse behandelt. In diesem Fall wird die Alterung wie eine Fertigungstoleranz behandelt.
  ◦ Alternative 2: Die Alterung korreliert mit Produktionstoleranzen und/oder der Nutzungsvariabilität. Dann muss diese durch Alterungsmodelle dargestellt werden. In diesen Fall müssen auch die zu überwachenden Eingangsgrößen des Alterungsmodells festgelegt werden. Zur Berücksichtigung einer beschleunigten Alterung wird eine jeweilige Beobachtungsperiode vorzugsweise in Stützpunkte aufgeteilt. Für jeden Stützpunkt wird das Motormodell nach den Alterungsmodellen korrigiert

In einem zweiten Arbeitsschritt wird der Modellierungsaufbau festgelegt. Hierzu gehören vorzugsweise:

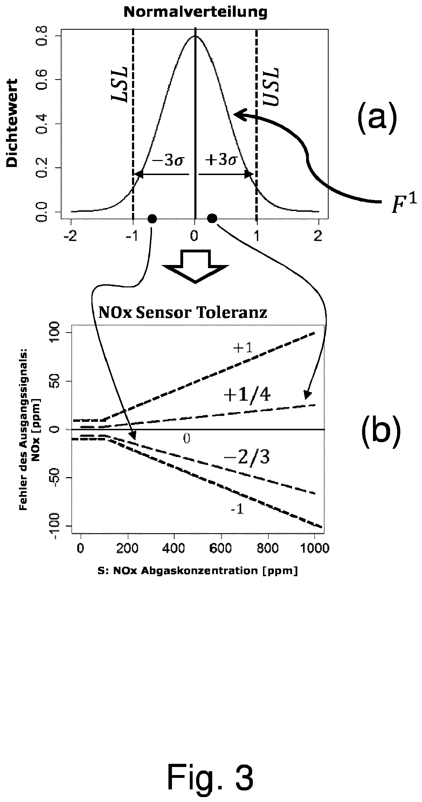

- Erzeugung und/oder Zuordnung von sogenannten Zugangspunkten, an welchen Faktorvariabilität, insbesondere die Produktions- und Messtoleranzen, auf das Modell übertragbar ist. Ein Beispiel für die Faktorvariabilität eines NOx-Sensors ist in Fig. 3a gezeigt
- Zugangspunkte können daher wie folgt unterschieden werden:

  ◦ Offsetfehler (z.B. Hardwareabmessungen, Sensorfehler), d.h, ein bestimmter Parameter oder Signal im Modell wird mit konstantem Wert vorbelegt
  ◦ Faktorfehler (z.B. Aktorfunktionalitäten, Sensorfehler), d.h. ein bestimmtes Signal im Modell wird mit einem Wert nahe 1 multipliziert
  ◦ Nichtlinearitätsfehler (z.B. abhängige Funktionalitäten, Sensorfehler), d.h. ein definiertes Signal weicht als Funktion von einem/mehreren Signalen ab; ein nichtlinearer Fehler bezieht sich auf eine Funktion zwischen den Spezifikationsbegrenzungen USL, LSL für einen bestimmten Motor (eine Betriebsverhalten-Simulation), für welchen dieser konstant gehalten wird. Ein Beispiel hierfür ist in Fig. 3b dargestellt

- Test der Zugangspunkt-Implementierung und des Datenflusses durch die gesamte Simulationsumgebung
- Prüfen der Korrektheit der Startbedingungen für Testläufe und korrigieren des Datenexports
- Überprüfen der Zugangspunkte auf die richtigen Abhängigkeiten, vorzugsweise durch eine One-Factor-a-Time (OFT) Simulation, bei welcher jeder Faktor zu seiner unteren (LSL) und oberen (USL) Spezifikationsbegrenzung verändert wird. Dies geschieht insbesondere an anspruchsvollen stationären Betriebspunkten oder bei einem transienten Zyklus.

Aus den vorgenannten Variabilitäten für Nutzung, Alterung, Umweltbedingungen und Produktions- und Messtoleranzen ergeben sich jeweils Randverteilungen $F^1$,..., $F^k$. Diese werden vorzugsweise in einer Gesamtverteilung $F^{1*..*k}$ zusammengefasst. Diese Gesamtverteilung spannt einen Versuchsraum $\mathbb{X}^k$ auf.

In einem dritten Arbeitsschritt wird ein Screening-Verfahren an der Gesamtverteilung $F^{1*..*k}$ durchgeführt. Das Screening-Verfahren dient dazu, die Gültigkeit der Simulationsumgebung an den Grenzen des Versuchsraumes $\mathbb{X}^k$ zu validieren. Bereiche mit hoher Variabilität können für eine effiziente raumfüllende Versuchsplanung identifiziert werden. In diesem Fall werden die Screening-Daten zur Erstellung eines raumfüllenden Designs benutzt. Darüber hinaus kann ein erster Überblick gewonnen werden, welcher Faktor für welche Systemantwort oder Zielgröße bedeutsam ist.

Andererseits kann das Screening-Verfahren eingesetzt werden, um langlebige Vorkonditionierungs- und Lernphasen von Komponenten des Fahrzeugs einzusparen und auf diese Weise die Toleranzbereiche der Eigenschaften der Komponenten zu reduzieren. Denn schon auf der Grundlage der Daten, welche in dem Screening-Verfahren gewonnen wurden, können Regressionsmodelle zweiter Ordnung für die Abhängigkeiten von Zielgrößen erstellt werden, auf deren Basis als Zielgrößen eine Veränderung der Toleranzen während der Lernphase einer Steuerung einer Komponente oder auch eine Beladung eines Katalysators während einer Konditionierungsphase vorhergesagt werden kann.

Vorzugsweise sollte das Screening-Design in der Lage sein, alle Faktoren auf den drei Ebenen "Nominal", "LSL" und "USL" zu untersuchen. Beispielsweise kann das Screening-Verfahren nach Jones und Nachtsheim, Journal of Quality Technology, Vol. 43, pp. 1-15, 2011 zum Einsatz kommen.

Mittels des Screening-Verfahrens kann die Bedeutung einzelner Faktoren durch ein t-Test Testverfahren untersucht werden. Diese Untersuchung bezieht vorzugsweise lineare Abhängigkeiten, quadratische Abhängigkeiten und Interaktionseffekte zwischen zwei Faktoren ein, wobei weiter vorzugsweise die Power jedes Tests (d.h. die Wahrscheinlichkeit für falsche Aussagen) untersucht wird.

In einem vierten Arbeitsschritt wird eine raumfüllende Versuchsplanung für die Gesamtverteilung $F^{1*..*k}$ in dem Versuchsraum $\mathbb{X}^k$ durchgeführt. Dies ist nötig, da Daten, die durch das Screening-Verfahren erhalten werden, in der Regel nicht ausreichen, um die Abhängigkeiten zwischen den Eigenschaften oder Konfigurationen einer Fahrzeuggattung und den Zielgrößen in einem Transformationsmodell TM für den gesamten Versuchsraum $\mathbb{X}^k$ hinreichend akkurat darzustellen.

Stichproben oder Realisierungen sind für die Betriebsverhalten-Simulation insbesondere in jenen Regionen des Versuchsraums $\mathbb{X}^k$ erforderlich, in welchen die zu untersuchenden Abhängigkeiten eine hohe Variabilität aufweisen.

Vorzugsweise wird die Durchführung der Betriebsverhalten-Simulation 203 hierfür in mehrere Simulationsabschnitte aufgeteilt:
In Simulationsabschnitt 1 werden die Screening-Ergebnisse verwendet, um so ein raumfüllendes Design für den Versuchsraum $\mathbb{X}^k$ zu erzeugen, welches mehr Stichproben in Regionen mit hoher Variabilität der Zielgrößen setzt. Für die so definierten Stichproben oder Realisierungen wird die Betriebsverhalten-Simulation durchgeführt.

In Simulationsabschnitt 2 werden die Ergebnisse des In Simulationsabschnitts 1 verwendet, um zu bestimmen, welche Regionen des Versuchsraum $\mathbb{X}^k$ nicht zufriedenstellend untersucht sind, d.h., die Daten der Zielgröße zeigen schwere Lücken, so dass mehr Daten erforderlich sind.

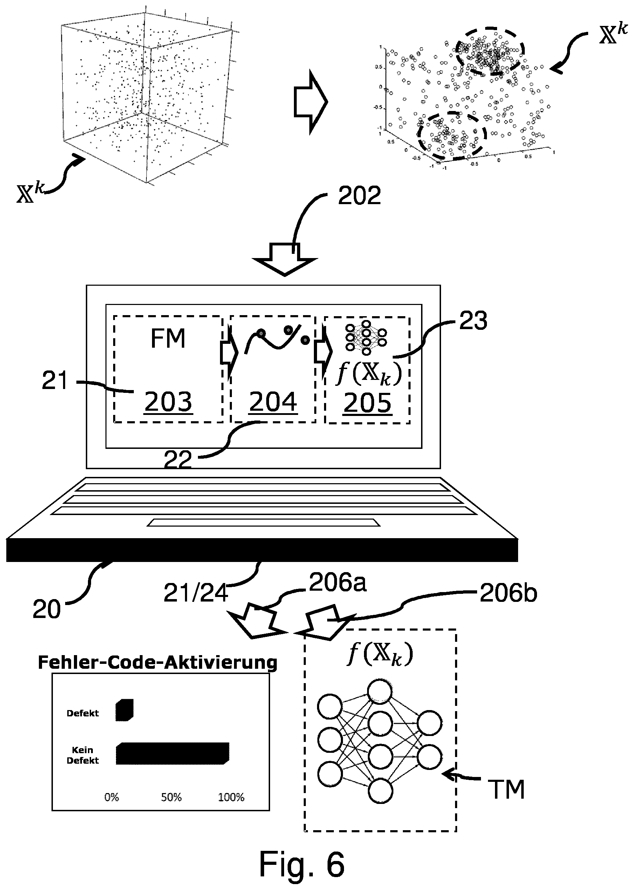

In diesen Regionen des Versuchsraum $\mathbb{X}^k$ werden erneut Stichproben oder Realisierungen ausgewählt. Eine solche verfeinerte Untersuchung von einzelnen Regionen ist in Fig. 6 dargestellt. Die entsprechenden Regionen weisen eine höhere Stichprobendichte auf und sind in Fig. 6 mittels gestrichelter Linien umrahmt.

Der Simulationsabschnitt 2 kann beliebig oft wiederholt werden, bis alle Abhängigkeiten zufriedenstellend untersucht sind.

In einem fünften Arbeitsschritt werden ein oder mehrere Transformationsmodelle TM, vorzugsweise für jede beobachtete Zielgröße, erzeugt 204. Das jeweilige Transformationsmodell TM ist hierbei nur innerhalb der untersuchten Toleranzgrenzen gültig.

Die Transformationsmodelle TM werden vorzugsweise auf der Grundlage von Regressions- und Mustererkennungsansätzen, insbesondere mehrschichtigen Perzeptronen ("Multi-Layer Perceptrons), d.h. neuronale Netzwerke, erstellt.

Trainingsalgorithmen, die für diese neuronalen Netzwerke verwendet werden können, finden sich beispielsweise als Teil der von Mathworks© angebotenen "Neural Networks Toolbox". Die Leistung der Transformationsmodelle TM wird durch hierfür speziell vorbehaltene Daten der Betriebsverhalten-Simulation beurteilt. Diese wird vorzugsweise als ausreichend angesehen, wenn das Bestimmtheitsmaß $R^2$ bezüglich aller Daten größer als 0,6 ist.

In einem sechsten Arbeitsschritt wird eine Monte-Carlo-Simulation zur Generierung von Zufallswerten, insbesondere in Bezug auf Konfigurationen, ausgeführt. Die größte Herausforderung ist hierbei die "vollständige" Einbindung einer gegebenen Unsicherheit in die Robustheitsanalyse. "Vollständig" bedeutet, dass die eingeschlossene Variabilität repräsentativ untersucht wird.

Nach dem "Gesetz der großen Zahlen", stellt eine Reihe von zufälligen Stichproben die zugrundeliegende Verteilung dar, wenn die Abweichung zwischen empirischen und theoretischen Quantilen hinreichend klein ist.

Eine solche Reihe von zufälligen Stichproben oder Realisierungen kann mittels der Monte-Carlo-Simulation aus der ursprünglichen Verteilung $F^{1^*\ldots^*k}$ generiert werden 101. Diese Stichproben oder Realisierungen werden in das oder die Transformationsmodelle TM eingegeben 102.

Für diese repräsentativen Stichproben oder Realisierungen kann die Verteilung der jeweils gewünschten Zielgröße mittels des oder der Transformationsmodelle TM berechnet werden 103, 205.

Durch den Einsatz der Transformationsmodelle TM können die Stichproben sofort verarbeitet werden und daher die Verteilung der Zielgröße ohne lange Simulationszeiten sofort berechnet werden.

Mittels der Ergebnisse der Berechnungen kann eine Sensitivitätsanalyse ausgeführt werden. Bei einer solchen Sensitivitätsanalyse haben die erfindungsgemäßen Transformationsmodelle TM den Vorteil, dass auch andere Gesamtverteilungen $F'^{1^*\ldots^*k}$, $F''^{1^*\ldots^*k}$ innerhalb des Versuchsraum $\mathbb{X}^k$ sofort analysiert werden können, ohne weitere zeitaufgelöste Betriebsverhalten-Simulationen durchführen zu müssen.

Beispielsweise kann die Signifikanz der Variation einzelner Eigenschaften durch Einschränkung ihrer Variabilität auf Sub-Intervalle untersucht werden. Die sich hieraus ergebende neue Gesamtverteilung $F'^{1^*\ldots^*k}$, $F''^{1^*\ldots^*k}$ kann mittels des wenigstens einen Transformationsmodells TM, welches für die ursprüngliche Gesamtverteilung $F^{1^*\ldots^*k}$ hergeleitet wurde, und einer erneuten Monte-Carlo-Simulation für die neue Gesamtverteilung untersucht werden. Auf diese Weise können die Zielgrößen erneut für die neue Gesamtverteilung $F'^{1^*\ldots^*k}$, $F''^{1^*\ldots^*k}$ bestimmt werden und dann die im Vergleich zur ursprünglichen Gesamtverteilung $F^{1^*\ldots^*k}$ erhaltene Differenz gemessen werden.

Diese Differenz drückt sich ohne Beschränkung der Allgemeinheit der Ergebnisse für das Fahrzeug oder die Fahrzeuggattung in einer Änderung der Wahrscheinlichkeit für ein vorgegebenes Ereignis aus.

In einem siebten Arbeitsschritt werden die Ergebnisse gedeutet.

Die auf der Grundlage der im Vorhergehenden beschriebenen Arbeitsschritte erhaltenen Wahrscheinlichkeiten oder Wahrscheinlichkeitsverteilungen für ein vorgegebenes Ereignis müssen in Bezug auf die Ziele der Robustheitsstudie interpretiert und/oder verarbeitet werden

Beispielsweise könnte es das Ziel der Robustheitsanalyse sein, die Produktkonformitäts-(CoP)Ausfallwahrscheinlichkeit für eine Hochleistungs-Straßen-Anwendung ("On-Road Heavy-Duty Motor") zu beurteilen.

Bei dem Produktkonformitäts-Prüfverfahren handelt es sich um einen statistischen Stichproben-Test, bei dem Motoren aus der Fertigungsreihe sukzessive auf Emissions-Compliance geprüft werden. Beginnend mit drei Motoren wertet das Prüfverfahren die Teststatistiken auf der Grundlage der gesetzlich geregelten Schadstoffe aus. Abhängig vom Ergebnis der Teststatistik ist die Produktkonformitätsprüfung bestanden, fehlgeschlagen oder es wird ein zusätzlicher Motor aus der Fertigungsreihe entnommen.

Den erhaltenen Wahrscheinlichkeitsverteilungen können Wahrscheinlichkeiten fürs Bestehen, Fehlschlagen oder die erwartete Anzahl an Motoren entnommen werden, für die die Produktkonformitätsprüfung getestet werden müssen.

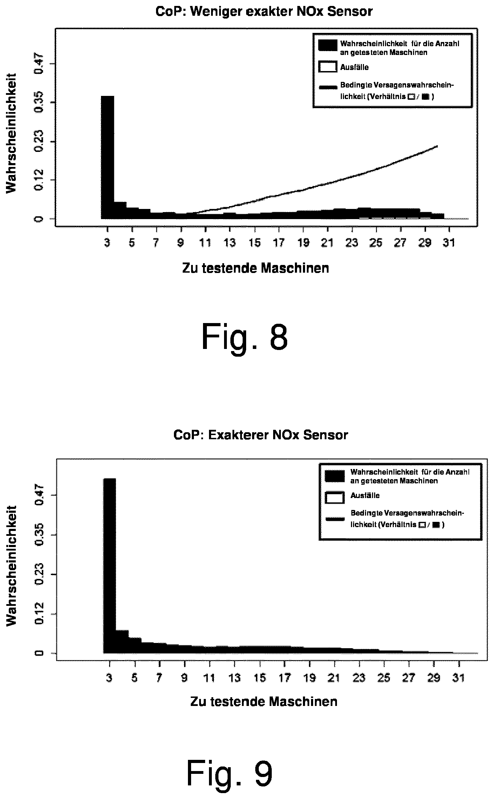

Die Figuren 8 und 9 zeigen die Wahrscheinlichkeitsverteilungen von Produktkonformitätsprüfung für NOx-Sensoren mit hoher (Fig. 9) und niedriger Qualität (Fig. 8), welche mittels der erfindungsgemäßen Verfahren 100, 200 ermittelt werden können.

Ein weiteres Beispiel zum Einsatz der erfindungsgemäßen Lehre ist die Frage, wie eine Toleranz in Bezug auf eine Eigenschaft geändert werden muss, um eine zufriedenstellende Wahrscheinlichkeitsverteilung der Zielgröße zu erhalten. Ein weiteres Beispiel ist die Beurteilung der Alterung der Komponenten in Bezug auf eine gegebene Toleranz. Die Wahrscheinlichkeitsverteilung der Zielgröße könnte hierbei beispielsweise Temperaturspitzen betreffen, die den Alterungsprozess eines Bauteils erheblich beeinflussen. Diese Wahrscheinlichkeitsverteilung könnte beispielsweise in Bezug auf erwartete Reparatur- und Garantiekosten interpretiert werden.

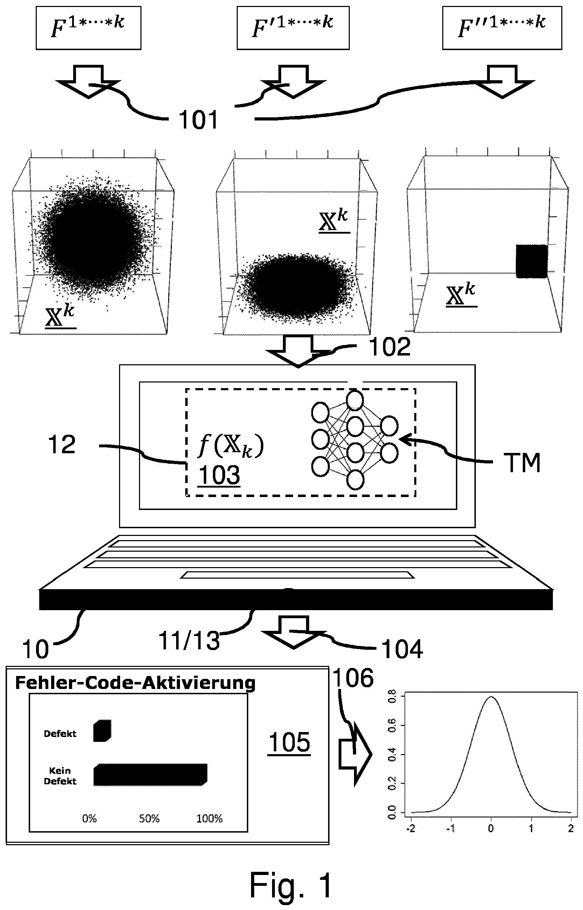

Die erfindungsgemäßen Verfahren 100, 200 betreffen vorzugsweise Teilaspekte der zuvor beschriebenen Bestimmung der Robustheit einer Fahrzeuggattung. Nachfolgend werden bevorzugte Ausführungsbeispiele der erfindungsgemäßen Verfahren 100, 200 insbesondere anhand der Figuren 1, 2 und 6 im Detail erläutert.

Fig. 1 zeigt ein Flussdiagramm eines Ausführungsbeispiels eines Verfahrens 100 zur Analyse einer Robustheit wenigstens eines Fahrzeugs einer Fahrzeuggattung.

Ausgangspunkt für dieses Ausführungsbeispiel sind die Gesamtverteilungen $F^{1*\ldots*k}$, $F'^{1*\ldots*k}$, $F''^{1*\ldots*k}$. Diese Gesamtverteilungen entstehen durch abhängige oder vorzugsweise unabhängige Zufallsvariablen $X_1,\ldots,X_k$ mit Randverteilungen $F^1,\ldots,F^k$, welche jeweils einen Aspekt der möglichen Schwankungen in Bezug auf ein Fahrzeug einer Fahrzeuggattung betreffen.

Solche Randverteilungen $F^1,\ldots,F^k$ in Bezug auf einzelne Aspekte der Schwankungen eines Fahrzeugs sind in den Figuren 3 bis 5 dargestellt.

Fig. 3a repräsentiert hierbei eine Schwankung in Bezug auf Produktionstoleranzen oder Messtoleranzen einer Komponente eines Fahrzeugs, welche im Allgemeinen einer parametrischen Verteilung, insbesondere einer Normalverteilung, unterliegt.

Im Allgemeinen werden die Produktionstoleranzen durch eine obere und untere Spezifikationsbegrenzung (Lower Specification Limit - LSL bzw. L, Upper Specification Limit - USL bzw. U) gekennzeichnet, welche im Allgemeinen bei +/- 4 $\sigma$, das heißt der vierfachen Standardabweichung, liegt. Dies bedeutet, dass man bei 100.000 zufälligen Stichproben erwarten kann, dass 6 Stück außerhalb dieser Grenzen liegen. Bei Sensoren wird allgemein von Messtoleranzen gesprochen, welche beispielsweise durch einen Offset- und/oder einen Gain- und/oder einen Nichtlinearitätsfehler verursacht werden. Diese Definition entspricht der ISO-Norm 11462.

Die hierdurch verursachte Messungenauigkeit wird von den Herstellern im Allgemeinen durch Angabe der Grenze von +/- 2 $\sigma$, das heißt der zweifachen Standardabweichung, als untere Spezifikationsbegrenzung bzw. obere Spezifikationsbegrenzung, angegeben. Dies bedeutet, dass 5 Stück aus 100 zufälligen Stichproben im Mittel außerhalb dieser Grenzen liegen. Diese Definition entspricht der DIN-Norm 1319.

Einige Hersteller von Messsensoren, wie beispielsweise Bosch, geben dagegen die Grenzen bei +/- 3 $\sigma$, das heißt der dreifachen Standardabweichung, an. Außerhalb dessen Grenzen liegen im Mittel lediglich 3 Stück von 1.000 zufälligen Stichproben.

Eine solche Randverteilung unter Angabe der unteren Spezifikationsgrenze LSL und der oberen Spezifikationsgrenze USL ist in Fig. 3a dargestellt. Eine typische Spezifikation der Messtoleranzen eines $NO_x$-Sensors lautet wie folgt:

- Bei einer Konzentration von $NO_x$ < 100 ppm ist der Toleranzbereich +/- 10 ppm bei +/- 3 $\sigma$;

- bei einer $NO_x$-Konzentration von > 100 ppm ist der Toleranzbereich +/- 10 % bei +/- 3 $\sigma$.

Aus dieser Spezifikationen der Messtoleranzen und/oder Produktionstoleranzen kann ein Fehler des Ausgabesignals abgeleitet werden, wie in Fig. 3b gezeigt. Die jeweiligen beispielhaften zufälligen Stichproben aus Fig. 1a verursachen hierbei, wie durch die beiden geschwungenen Pfeile angedeutet, zu den jeweiligen Fehlerkurven in Abhängigkeit der $NO_x$-Konzentrationen im Abgas.

Ähnliche Verteilungen können auch zur Abbildung von Alterungsprozessen einzelner Komponenten herangezogen werden. In diesem Fall ist das Altern eine unabhängige Eingangsgröße der Robustheitsanalyse.

Alternativ dazu kann das Altern mit Produktionstoleranzen und der Nutzungsvariabilität korreliert werden. Hierfür werden vorzugsweise separate Alterungsmodelle erstellt. Dies umfasst das Festlegen von Eingangsgrößen des Alterungsmodells, z. b. eine Laufleistung. Bei der Betriebsverhalten-Simulation müssen dann die einzelnen Modelle der Komponenten auf der Grundlage des oder der Alterungsmodell(e) korrigiert werden.

Fig. 4 stellt eine Verteilung in Bezug auf die Nutzungsschwankungen von Fahrzeugen einer Fahrzeuggattung dar.

Wie in der Figur aber angedeutet, erfolgt das Erstellen einer solchen Verteilung auf der Grundlage von Rohdaten, welche an bestehenden Fahrzeugen im Feld gesammelt wurden. Die Rohdaten können hierbei an Fahrzeugen aufgenommen werden, welche nicht zur gleichen Fahrzeuggattung wie jene gehören, in Bezug auf welche später eine Robustheitsanalyse durchgeführt wird. Vorzugsweise werden für eine Sammlung von Rohdaten mehrere 100 bis mehrere 1000 Fahrten ausgewertet. Hierbei werden als Messkanäle vorzugsweise die Fahrzeuggeschwindigkeit, eine zurückgelegte Kilometerzahl, die Motordrehzahl, ein Drehmoment, eine Gaspedalposition, ein Bremssignal, ein Kupplungssignal, eine Kupplungsposition, eine Höhe, eine Umgebungstemperatur und eine Umgebungsluftfeuchtigkeit berücksichtigt.

Vorzugsweise wird aus diesen Daten eine Verteilung erzeugt, welche die Verteilungsdichte von einzelnen gefahrenen Zyklen in Bezug auf die Last und die Fahrdynamik angeht, wie dies in Fig. 4 dargestellt ist.

In Fig. 4 sind hierbei durch die drei Linien jeweils Bereiche begrenzt, in welchen 99,99 % bzw. 99,73 % bzw. 95 % der gefahrenen Zyklen enthalten sind. Aus der Dichteverteilung der Zyklen in Bezug auf Last und Dynamik wird ein 17 Stunden-Referenzzyklus bestimmt. In der Dichteverteilung werden maßgebliche Bereiche identifiziert, welche in Fig. 4 durch S bezeichnet sind, in welchen Fehlfunktionen der Komponenten der Fahrzeuge, insbesondere des Motors, vermehrt auftreten. In dem vorliegenden Ausführungsbeispiel wird der Referenzzyklus vorzugsweise auf diese maßgeblichen Bereiche verkürzt, wodurch ein verkürzter Referenzzyklus R von etwa 30 Minuten übrig bleibt. Dieser verkürzte Zyklus wird zur Abbildung der Betriebsbedingungen angenommen, unter welchen alle Fahrzeuge der Fahrzeuggattung betrieben werden. Alternativ kann aber auch vorgesehen sein, dass die Fahrzeuge der Fahrzeuggattung auch hinsichtlich verschiedener Fahrzyklen differenziert werden.

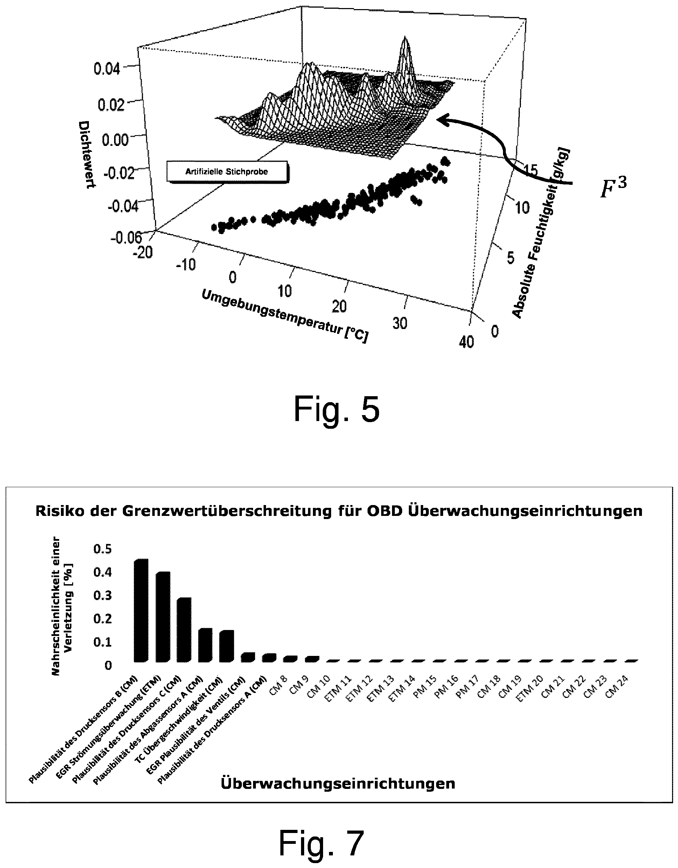

Fig. 5 stellt eine Randverteilung für die Variabilität von Umweltbedingungen, im dargestellten Fall Luftdichte, Temperatur und absolute Luftfeuchtigkeit, dar, unter welcher die Fahrzeuge der Fahrzeuggattung betrieben werden. Auch diese Daten können aus den Rohdaten, welche im Feld gewonnen wurden, hergeleitet werden.

Weitere Aspekte, welche die Robustheit eines Fahrzeugs beeinflussen, können durch weitere Randverteilungen $F^x$ berücksichtigt werden.

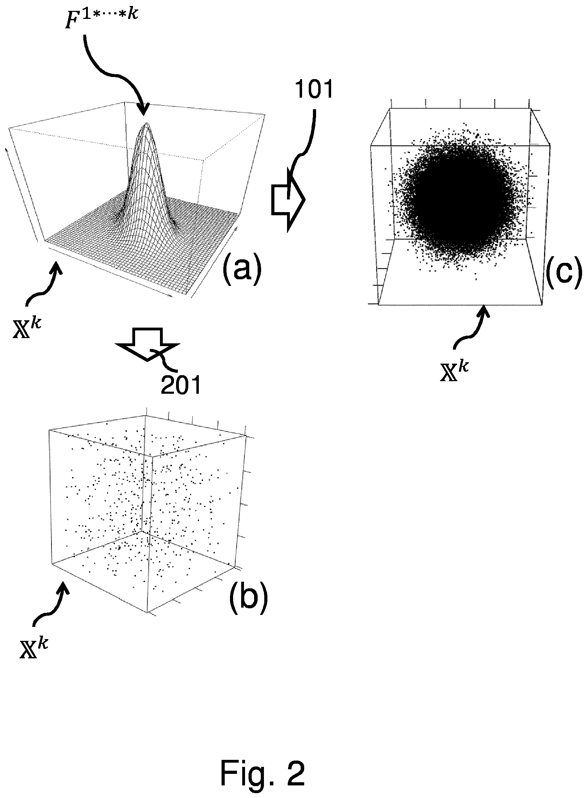

Die einzelnen Randverteilungen in $F^1,...,F^k$ werden, sofern vorhanden, über Korrelationsstrukturen zu einer Gesamtverteilung $F^{1*...*k}$ zusammengefasst, welche in einem k-dimensionalen Versuchsraum $\mathbb{X}^k$ aufgespannt ist. Ein solcher Versuchsraum $\mathbb{X}^k$ ist in Fig. 2 dreidimensional dargestellt.

In einer beispielhaften Robustheitsanalyse wird das Risiko einer fehlerhaften Aktivierung von 24 Fehlercodes bzw. Fehlermeldungen eines Fahrzeugs untersucht. Durch die verschiedenen, an der Feststellung solcher Fehlercodes beteiligten, Komponenten des Fahrzeugs, insbesondere die Sensoren, ergeben sich hierbei durch die Produktions- und Messtoleranzen 38 Zufallsvariablen, also 38 Dimensionen.

Die Berücksichtigung der Alterungseffekte der Komponenten fügt zwei weitere Dimensionen oder Zufallsvariablen hinzu.

Die Nutzung der Fahrzeuge der Fahrzeuggattung wird durch einen repräsentativen Fahrzyklus berücksichtigt. Liegen bei der Nutzung größere Schwankungen vor, kann auch hier eine Zufallsvariable vorgesehen sein. Schließlich werden in dem Beispiel die Umweltbedingungen ebenfalls durch eine Zufallsvariable, insbesondere einen zweidimensionalen Zufallsvektor, berücksichtigt.

In dem Beispiel ergibt sich damit ein Versuchsraum mit 42 Dimensionen.

Eine grafische Darstellung einer Gesamtverteilung, zur besseren Darstellbarkeit auf drei Dimensionen reduziert, ist in Fig. 2 als Verteilungskurve $F^{1*...*k}$ gezeigt, welche in dem Versuchsraum $\mathbb{X}^k$ aufgespannt ist.

Jede Realisierung oder jede Stichprobe aus der Gesamtverteilung $F^{1*...*k}$ entspricht hierbei einem Fahrzeug der Fahrzeuggattung mit einer bestimmten Konfiguration.

Eine solche Konfiguration wird beispielsweise festgelegt durch die Eigenschaften der Komponenten des jeweiligen Fahrzeugs, insbesondere deren bestimmte Produktions- und/oder Messtoleranzen, eine Nutzung der Komponenten des Fahrzeugs oder des Fahrzeugs selbst, insbesondere in Form eines bestimmten charakteristischen Fahrzyklus, bestimmte Umgebungsbedingungen, unter welchen das Fahrzeug betrieben wurde, sowie eine gewisse Alterungsstruktur der Komponenten des Fahrzeugs oder des Fahrzeugs selbst.

Je nachdem, welche Eigenschaften der Fahrzeuggattung als Randverteilung gegeben sind bzw. welche Eigenschaften eine Fahrzeuggattung aufweist, und je nachdem, welche Eigenschaften deterministisch festgelegt sind, ergeben sich dabei verschiedene Gesamtverteilungen $F^{1*...*k}$, $F'^{1*...*k}$, $F''^{1*...*k}$.

Wie in Fig. 1 und Fig. 2 dargestellt, wird aus der jeweiligen Gesamtverteilung $F^{1*...k}$, $F'^{1*...k}$, $F''^{1*...*k}$ eine Gruppe von Fahrzeugen in Arbeitsschritt 101 ausgewählt, welche vorzugsweise eine repräsentative Auswahl an Stichproben aus der jeweiligen Gesamtverteilung $F^{1*...*k}$, $F'^{1*...*k}$, $F''^{1*...*k}$ darstellt.

Alternativ zu einer gesamten Fahrzeuggattung oder einer Gruppe von Fahrzeugen aus der Fahrzeuggattung können auch einzelne Fahrzeuge mit der Erfindung analysiert werden. Hierfür werden vorzugsweise alle verfügbaren Variablen von Eigenschaften in Bezug auf die Komponenten des Fahrzeugs deterministisch festgelegt. In diesem Fall wird ein einzelnes Fahrzeug mit ganz bestimmten Produktionstoleranzen und/oder Messtoleranzen definiert, welches beispielsweise unter Berücksichtigung einer Verteilung der Umgebungsbedingungen betrieben wird oder auch unter Berücksichtigung einer Verteilung von Fahrzyklen betrieben wird. In diesem Fall wird somit ein Fahrzeug mit ganz bestimmten Eigenschaften der Komponenten, aber variablen Eigenschaften einer Nutzung dieses Fahrzeugs, betrachtet.

Hierdurch kann mittels der Erfindung eine detaillierte Ursachenanalyse in Bezug auf die Robustheit ausgeführt werden. Insbesondere kann jeweils eine Variable in Bezug auf eine Eigenschaft variiert werden, während alle anderen Variablen festgehalten werden und die Auswirkungen auf die Zielgröße in Bezug auf die Robustheit, insbesondere die Auswirkungen auf eine Wahrscheinlichkeitsverteilung bzw. Wahrscheinlichkeitsfunktion im diskreten Fall oder einer Verteilungsfunktion im stetigen Fall der Zielgröße, analysiert werden. Darüber hinaus können Design-Validierungs-Pläne unterstützt werden, indem kritische Anwendungsbereiche identifiziert werden. Schließlich kann durch Verändern der Konfigurationen unter Beobachtung der Entwicklung der Zielgrößen, insbesondere der Auswirkungen auf eine Wahrscheinlichkeitsverteilung bzw. Wahrscheinlichkeitsfunktion im diskreten Fall oder einer Verteilungsfunktion im stetigen Fall der Zielgröße, eine Optimierung vorgenommen werden.

Wie eingangs beschrieben, kann eine repräsentative Auswahl aus der jeweiligen Gesamtverteilung $F^{1*...*k}$, $F'^{1*...k}$, $F''^{1*...*k}$ durch ein Zufallsexperiment, insbesondere eine Monte-Carlo-Simulation, erstellt werden. Hierbei werden vorzugsweise so viele zufällige Stichproben benötigt, bis die Eigenschaften der theoretischen Verteilung, insbesondere die theoretischen Quantile, mit den Eigenschaften der im Zufallsexperiment resultierenden empirischen Verteilung, insbesondere den empirischen Quantilen, übereinstimmen.

Die jeweilige repräsentative Auswahl wird, wie in Fig. 1 gezeigt, in einem weiteren Arbeitsschritt 102 einem Transformationsmodell TM zugeführt.

Das Transformationsmodell TM weist eine Zuordnungsvorschrift, insbesondere eine Funktion oder eine Tabelle, auf, welche zwischen den Konfigurationen, vorzugsweise einer repräsentativen Auswahl einer Vielzahl von Konfigurationen, der Gruppe aus Fahrzeugen oder der Fahrzeuggattung und wenigstens einer Zielgröße oder einer Gruppe aus Zielgrößen einen Zusammenhang herstellt. Anhand der Werte, welche für diese Zielgröße bestimmt werden, kann erfindungsgemäß die Robustheit des Fahrzeugs, der Gruppe von Fahrzeugen oder der gesamten Fahrzeuggattung charakterisiert werden. Insbesondere kann anhand der Resultate eine Wahrscheinlichkeit angegeben werden, mit welcher ein gewisses Ereignis, insbesondere ein Wert, oder Ereignisse, insbesondere Werte, eintreten. Dies kann beispielsweise das unerwünschte Auftreten eines Fehlercodes oder einer Fehlermeldung sein, oder auch mit welcher Wahrscheinlichkeit eine Emissionsgrenze überschritten oder eingehalten wird. Grundsätzlich kann hierbei aber jede Art von Zielgröße in Bezug auf das Fahrzeug in Bezug auf seine Robustheit analysiert werden. Insbesondere können auch Kombinationen von Auftrittswahrscheinlichkeiten in Bezug auf zwei oder mehrere Zielgrößen analysiert werden. Mittels des Transformationsmodells TM werden in einem Arbeitsschritt 103 Werte der Zielgröße bestimmt.

Der Wert der Zielgröße wird schließlich, wie in Fig. 1 gezeigt, in Arbeitsschritt 104 ausgegeben. Eine Ausgabe kann hierbei sowohl über ein Display erfolgen als auch durch ein Bereitstellen an einer Datenschnittstelle. In Fig. 1 wird beispielhaft eine Ausfallwahrscheinlichkeit und eine Nicht-Ausfallwahrscheinlichkeit ausgegeben.

Alternativ oder zusätzlich kann in einem weiteren Arbeitsschritt 105 eine Wahrscheinlichkeit eines Werts oder einer Wahrscheinlichkeitsverteilung einer Zielgröße oder eine Verteilungsfunktion der Zielgröße auf der Grundlage der bestimmten Werte berechnet werden. Dies erfolgt mit bekannten Verfahren der Statistik. Auch diese Wahrscheinlichkeit oder Wahrscheinlichkeitsverteilung wird vorzugsweise ausgegeben 106.

Im erweiterten Sinn kann man bei dem Wert der Zielgröße, welche in dem Arbeitsschritt 103 bestimmt wird, daher auch von einem Wahrscheinlichkeitswert sprechen. Insbesondere werden erfindungsgemäß alle Werte der Zielgröße einer repräsentativen Auswahl von Fahrzeugen bestimmt. Anhand dieser Werte kann die Wahrscheinlichkeit eines einzelnen Werts, eine Wahrscheinlichkeitsverteilung einer Zielgröße oder eine Verteilungsfunktion der Zielgröße ermittelt werden.

Das erfindungsgemäße Verfahren 100 zur Analyse einer Robustheit wenigstens eines Fahrzeugs einer Fahrzeuggattung wird vorzugsweise durch ein entsprechendes System 10 ausgeführt. Dieses System 10 weist vorzugsweise Mittel oder Module auf, welche softwaretechnisch oder hardwaretechnisch implementiert sein können. Vorzugsweise weist ein solches System 10 Mittel 11 zum Erfassen von Konfigurationen des wenigstens einen Fahrzeugs, vorzugsweise eine Schnittstelle, Mittel 12 zum Bestimmen eines Werts einer Zielgröße in Bezug auf die Robustheit des wenigstens einen Fahrzeugs mittels des Transformationsmodells TM sowie eine Schnittstelle 13 zum Ausgeben des ermittelten bzw. bestimmten Werts auf. Auch das Treffen einer repräsentativen Auswahl von Konfigurationen, welche erfasst werden, kann vorzugsweise durch weitere Mittel des Systems 10 ausgeführt werden.

Fig. 7 zeigt ein weiteres Ergebnis, welches von dem erfindungsgemäßen Verfahren 100 in Arbeitsschritt 104 ausgegeben werden kann. Hierbei handelt es sich um eine Vielzahl an möglichen Fehlercodes oder Fehlermeldungen, deren Auftrittswahrscheinlichkeit mittels des erfindungsgemäßen Verfahrens bestimmt wurde. Hierzu weist ein erfindungsgemäßes Transformationsmodell TM eine Vielzahl von Zuordnungsvorschriften auf, welche den Konfigurationen, welche einem Fahrzeug, einer Gruppe von Fahrzeugen einer Fahrzeuggattung oder der gesamten Fahrzeuggattung eine Zielgröße in Bezug auf die Robustheit, im vorliegenden Fall eine Wahrscheinlichkeit, zuordnen.

Das Transformationsmodell TM, welches in den erfindungsgemäßen Verfahren 100, 200 zum Einsatz kommt, beruht vorzugsweise auf einer Betriebsverhalten-Simulation einer Vielzahl von Fahrzeugen der Fahrzeuggattung.

Die Betriebsverhalten-Simulation wird vorzugsweise mittels eines Fahrzeugmodells FM durchgeführt, welches das Betriebsverhalten jeweils eines Fahrzeugs der Fahrzeuggattung simuliert.

Das Fahrzeugmodell FM, welches den Antriebsstrang der Fahrzeuge der Fahrzeuggattung oder das gesamte Fahrzeug oder eine sonstige Baugruppe abbildet, wird vorzugsweise auf einem virtuellen Prüfstand betrieben, der eine sogenannte Hardware in the Loop (HiL)-Simulation durchführt.

Weitere Möglichkeiten zur Generierung von Messdaten oder simulierten Messdaten aus einer Betriebsverhalten-Simulation, anhand welcher das Transformationsmodell TM gebildet werden kann, sind Software in the Loop (SiL), Model in the Loop (MiL), Versuch an einem Komponentenprüfstand, an einem Motorprüfstand, an einer Fahrzeugrolle, an einem realen Fahrzeug, an einem Powertrain Prüfstand, oder eine Auswertung kombinierter Möglichkeiten zur Betriebsverhalten-Simulation, insbesondere Big Data.

Der virtuelle Prüfstand ist in Fig. 6 durch einen Computer 20 dargestellt. Auf diesem kann vorzugweise ein Verfahren zur Analyse einer Robustheit einer Fahrzeuggattung 200 ausgeführt werden.

In einem Arbeitsschritt 202 des Verfahrens 200 wird vorzugsweise ein Betriebsverhalten von Fahrzeugen der Fahrzeuggattung simuliert.

Ziel dieser Betriebsverhalten-Simulation ist es dabei, Abhängigkeiten zwischen verschiedenen Konfigurationen der Fahrzeuggattung und den Zielgrößen, welche eine Robustheit einer Komponente der Fahrzeuggattung oder der Fahrzeuge der Fahrzeuggattung charakterisieren, herzustellen, mithin die Zuordnungsvorschriften zwischen den Konfigurationen und den Zielgrößen empirisch zu entwickeln. Hieraus kann in einem nächsten Schritt das Transformationsmodell TM abgeleitet werden.

Die zu identifizierenden Zuordnungsvorschriften decken vorzugsweise den gesamten Versuchsraum $\mathbb{X}^k$ ab.

Um nicht den gesamten Versuchsraum $\mathbb{X}^k$, das heißt jeden einzelnen Betriebspunkt des Versuchsraums $\mathbb{X}^k$ vermessen oder zumindest eine Rastervermessung des Versuchsraums $\mathbb{X}^k$ durchführen zu müssen, ist erfindungsgemäß vorzugsweise vorgesehen, innerhalb der Grenzen der möglichen Schwankungen der Eigenschaften der Gesamtverteilung $F^{1*\ldots*k}$ einen statistischen Versuchsplan (Design of Experiments - DOE) in einem Arbeitsschritt 201 anzuwenden. Mittels dieses Arbeitsschritts 201, welcher in Fig. 2 dargestellt ist, kann der gesamte Versuchsraum $\mathbb{X}^k$ auf Zusammenhänge zu einer oder mehreren Zielgrößen in Bezug auf die Robustheit der Fahrzeuge mit einem überschaubaren Simulationsaufwand untersucht werden.

Zur statistischen Versuchsplanung können hierbei an sich bekannte Verfahren zum Einsatz kommen. Beispielsweise kann, wie weiter oben beschrieben, eine statistische Versuchsplanung nach Jones und Nachtsheim, Journal of Quality Technology, Vol. 43, pp. 1-15, 2011 zum Einsatz kommen. Insbesondere kann die Betriebsverhalten-Simulation, wie ebenfalls weiter oben beschrieben, in mehrere Simulationsabschnitte aufgeteilt werden.

Vorzugsweise wird bei der erfindungsgemäß angewandten statistischen Versuchsplanung in einem Simulationsabschnitt 1 ein Sensitivitäts-Screening durchgeführt, wobei jede Eigenschaft an drei Punkten des Versuchsraums $\mathbb{X}^k$ untersucht wird, um einen ersten Eindruck vom Verhalten der einzelnen Eigenschaften auf die Zielgrößen zu erhalten.

In einem Simulationsabschnitt 2 wird ein raumfüllendes Design von Stichproben erstellt, welches es ermöglicht, die Sensitivität zwischen den Eigenschaften und den Zielgrößen detailliert auf der Grundlage von Messungen zu untersuchen.

Für jene Bereiche, welche durch raumfüllendes Design nicht gut abgedeckt wurden bzw. in welchen in dem Simulationsabschnitt 3 starke Veränderungen festgestellt werden, wird in einem dritten Arbeitsschritt ein weiteres raumfüllendes Design erstellt und die daraus resultierenden Stichproben in der Betriebsverhalten-Simulation angefahren, um eine möglichst genaue Zuordnungsvorschrift ermitteln zu können.

In dem vorliegenden Ausführungsbeispiel werden vorzugsweise in einem Versuchsraum $\mathbb{X}^k$ mit 42 Dimensionen auf diese Weise 600 Konfigurationen in Arbeitsschritt 201 identifiziert, deren Betriebsverhalten-Simulation mittels des Fahrzeugsmodells FM in Arbeitsschritt 203 ausreichend Informationen bereitstellt, um Zuordnungsvorschriften $f(\mathbb{X}^k)$ zwischen den Konfigurationen und den Zielgrößen, welche die Robustheit der Komponenten oder der Fahrzeuge oder der Fahrzeuggattung charakterisieren, zu ermitteln.

Die Zuordnungsvorschriften $f(\mathbb{X}^k)$ können letztendlich durch eine Regression in Arbeitsschritt 204 ermittelt werden. Vorzugsweise kommen für die Regression statistische Regressionsverfahren zum Einsatz.

Die empirisch ermittelten Zuordnungsvorschriften können schließlich zu einem empirischen Transformationsmodell TM zusammengefügt werden, welches, wenn dieses in Arbeitsschritt 205 angewendet wird, geeignet ist, eine Zielgröße in Bezug auf die Robustheit der Fahrzeugflotte in Arbeitsschritt 206a auszugeben. Alternativ oder zusätzlich kann auch das Transformationsmodell selbst in Arbeitsschritt 206b ausgegeben werden.

Das auf der Grundlage der Gesamtverteilung $F^{1*\ldots*k}$ ermittelte Transformationsmodell TM eignet sich dazu, auch andere, zweite, Gesamtverteilungen $F'^{1*\ldots*k}$, $F^{1'''*\ldots*k}$ in Bezug auf dieselbe Fahrzeuggattung zu untersuchen. Vorzugsweise liegen die Schwankungsbereiche der Eigenschaften dieser anderen Gesamtverteilungen $F'^{1*\ldots*k}$, $F^{1'''*\ldots*k}$ innerhalb der Schwankungsbereiche, die in Bezug auf die erste Verteilung ($F^{1*\ldots*k}$) vorgegeben sind.

Entsprechend weist der Computer oder ein anderes System 20 Mittel oder Module auf, welche hardwaretechnisch oder softwaretechnisch implementiert sind und eingerichtet sind, um das Verfahren 200 auszuführen. So weist der Computer oder das System 20 Mittel zum Verfassen von Konfigurationen einer Vielzahl von Fahrzeugen der Fahrzeuggattung auf. Dieses oder diese Mittel können insbesondere als Datenschnittstelle oder als Benutzerschnittstelle eingerichtet sein, so dass die Konfigurationen eingelesen werden können. Des Weiteren weist der Computer oder das System 20 Mittel zum Simulieren von Betriebsverhalten der Vielzahl von Fahrzeugen mit jeweils verschiedener Konfiguration, Mittel 21 eines Fahrzeugmodells FM der Fahrzeuggattung, Mittel 22 zum Durchführen einer Regression auf der Grundlage des simulierten Betriebsverhaltens der Vielzahl von Fahrzeugen sowie Mittel 23 zum Anwenden eines Transformationsmodells TM auf der Grundlage der Regression, auf. Schließlich weist der Computer oder das System 20 eine weitere Schnittstelle auf, eingerichtet, um den Wert der Zielgröße in Bezug auf die Robustheit und/oder das Transformationsmodell TM an sich auszugeben. Auch das Treffen einer Auswahl von Konfigurationen mittels statistischer Versuchsplanung, welche erfasst werden, kann vorzugsweise durch weitere Mittel des Systems 10 ausgeführt werden.

Bei den im Vorhergehenden beschriebenen Ausführungsbeispielen handelt es sich lediglich um Beispiele, die den Schutzbereich, die Anwendung und den Aufbau der erfindungsgemäßen Verfahren und Systeme in keiner Weise einschränken sollen. Vielmehr wird dem Fachmann durch die vorausgehende Beschreibung ein Leitfaden für die Umsetzung von mindestens einem Ausführungsbeispiel gegeben, wobei diverse Änderungen, insbesondere im Hinblick auf die Funktion und Anordnung der beschriebenen Bestandteile, vorgenommen werden können, ohne den Schutzbereich zu verlassen, wie er sich aus den Ansprüchen und dessen äquivalenten Merkmalskombinationen ergibt.

**Bezugszeichenliste**

TM Transformationsmodell
FM Fahrzeugmodell
$F^1$ Randverteilung
$F^k$ k-te Randverteilung
k-dimensionaler Verteilungsraum

$f(\mathbb{X}^k)$ Zuordnungsvorschrift

10 System zur Analyse einer Robustheit wenigstens eines Fahrzeugs einer Fahrzeuggattung
11 Mittel zum Erfassen
12 Mittel zum Bestimmen

13 $\mathbb{X}^k$ Schnittstelle
20 System zur Analyse einer Robustheit einer Fahrzeuggattung
21 Mittel zum Simulieren
22 Mittel zum Durchführen
23 Mittel zum Anwenden
24 Schnittstelle

**Patentansprüche**

1. Computer-gestütztes Verfahren (100) zur Analyse einer Robustheit einer Vielzahl von Fahrzeugen einer Fahrzeuggattung, welche eine Vielzahl an Komponenten aufweisen, folgende Arbeitsschritte aufweisend:

Erfassen (102) von Konfigurationen der Vielzahl von Fahrzeugen, welche durch wenigstens eine Eigenschaft wenigstens einer Komponente der Fahrzeuge charakterisiert sind;

Bestimmen (103) jeweils eines Werts einer Zielgröße in Bezug auf die Robustheit der Vielzahl von Fahrzeugen mittels eines Transformationsmodells (TM), welches eine Zuordnungsvorschrift ( $f(\mathbb{X}^k)$ ) zwischen Konfigurationen der Vielzahl von Fahrzeugen und der einen Zielgröße aufweist, wobei das Transformationsmodell (TM) auf einer Ausgleichsrechnung bezüglich Simulationergebnissen beruht, welche aus einer Betriebsverhalten-Simulation einer Vielzahl von Fahrzeugen der Fahrzeuggattung mit jeweils verschiedenen Konfigurationen mittels eines Fahrzeugmodells (FM) der Fahrzeuggattung resultieren; und
Ausgeben (104) der Werte.

2. Computer-gestütztes Verfahren (200) zur Analyse einer Robustheit einer Fahrzeuggattung, deren Fahrzeuge eine Vielzahl an Komponenten aufweisen, folgende Arbeitsschritte aufweisend:

Erfassen (202) von Konfigurationen einer Vielzahl von Fahrzeugen der Fahrzeuggattung, welche jeweils durch wenigstens eine Eigenschaft wenigstens einer Komponente des Fahrzeugs charakterisiert sind;
Simulieren (203) von Betriebsverhalten der Vielzahl von Fahrzeugen mit jeweils verschiedener Konfiguration mittels eines Fahrzeugmodells (FM) der Fahrzeuggattung, wobei jede Konfiguration wenigstens eine Eigenschaft einer Komponente wenigstens eines Fahrzeugs der Fahrzeuggattung charakterisiert;
Durchführen (204) einer Ausgleichsrechnung auf der Grundlage des simulierten Betriebsverhaltens der Vielzahl von Fahrzeugen; und
Anwenden (205) eines Transformationsmodells (TM) auf der Grundlage der Ausgleichsrechnung, wobei das Transformationsmodell (TM) eine Zuordnungsvorschrift ($f(\mathbb{X}^k)$) zwischen Konfigurationen und wenigstens einer Zielgröße umfasst, wobei das Transformationsmodell (TM) eingerichtet ist, auf der Grundlage von Konfigurationen der Fahrzeuggattung einen Wert einer Zielgröße in Bezug auf die Robustheit der Fahrzeuggattung auszugeben (206a, 206b).

3. Verfahren nach einem der vorhergehenden Ansprüche, des Weiteren folgenden Arbeitsschritt aufweisend:

Berechnen (105) einer Wahrscheinlichkeit eines Werts oder einer Wahrscheinlichkeitsverteilung einer Zielgröße oder einer Verteilungsfunktion der Zielgröße auf der Grundlage der bestimmten Werte; und

Ausgeben (106) der Wahrscheinlichkeit oder der Wahrscheinlichkeitsverteilung.

4. Verfahren nach einem der vorhergehenden Ansprüche, des Weiteren folgenden Arbeitsschritt aufweisend:

Erzeugen (101) einer repräsentativen Auswahl von Fahrzeugen einer Gruppe von Fahrzeugen der Fahrzeuggattung oder einer repräsentativen Auswahl von Fahrzeugen der gesamten Fahrzeuggattung, deren Konfigurationen erfasst werden; oder
Erzeugen (101) einer repräsentativen Auswahl von Konfigurationen der Vielzahl von Fahrzeugen.

5. Verfahren nach einem der vorhergehenden Ansprüche, wobei für eine Konfiguration eine Vielzahl an Eigenschaften einer Vielzahl an Komponenten erfasst werden und das Transformationsmodell (TM) geeignet ist, aus dieser Konfiguration einen oder wenige Zielgrößenwerte in Bezug auf das wenigstens eine Fahrzeug zu bestimmen.

6. Verfahren nach einem der vorhergehenden Ansprüche, wobei die Simulation oder das Simulieren auf einer Auswahl an Konfigurationen beruht, welche mittels statistischer Versuchsplanung (DoE) innerhalb von Grenzen einer ersten Verteilung ($F^{1*...*k}$) aller möglichen Konfigurationen ausgewählt (101, 201) wird.

7. Verfahren nach einem der Ansprüche 4 bis 6, wobei die repräsentative Auswahl innerhalb von Grenzen einer zweiten Verteilung ($F'^{1*...*k}$) ausgewählt ist, bei welcher die Schwankungsbereiche der Eigenschaften vorzugsweise innerhalb der Schwankungsbereiche liegen, die bei der ersten Verteilung ($F^{1*...*k}$) vorgegeben sind.

8. Verfahren nach Anspruch 6 oder 7, wobei die Zahl der Dimensionen (k) der ersten und/oder zweiten Verteilung ($F^{1*...*k}$, $F'^{1*...*k}$) gleich der Anzahl der Eigenschaften ist, welche in den Konfigurationen berücksichtigt ist.

9. Verfahren nach einem der vorhergehenden Ansprüche, wobei die wenigstens eine Eigenschaft in Bezug auf das Fahrzeug aus der folgenden Gruppe ausgewählt ist: eine Mess- und/oder Produktionstoleranz wenigstens einer Komponente des Fahrzeugs, eine Alterung wenigstens einer Komponente und/oder des wenigstens einen Fahrzeugs, eine Nutzung wenigstens einer Komponente und/oder des wenigstens einen Fahrzeugs, insbesondere mittels charakteristischer Fahrzyklen, und/oder wenigstens eine Umgebungsbedingung, unter welcher eine Nutzung erfolgt.

10. Verfahren nach einem der vorhergehenden Ansprüche, wobei die wenigstens eine Eigenschaft durch parametrische oder nicht-parametrische Wahrscheinlichkeitsverteilungen ($F^1,F^2,F^3,...,F^k$) und/oder deren Korrelationsgrößen angegeben ist.

11. Verfahren nach einem der vorhergehenden Ansprüche, wobei die wenigstens eine Eigenschaft und/oder weitere Eigenschaft auf der Grundlage der ausgegebenen Werte der Zielgröße, einer aus Zielgrößen gebildeten Zielfunktion, einer Wahrscheinlichkeit eines Werts der Zielgröße und/oder einer Wahrscheinlichkeitsverteilung der Zielgröße verändert wird, wobei vorzugsweise die übrigen Eigenschaften festgelegt sind.

12. Verfahren nach einem der vorhergehenden Ansprüche, wobei die wenigstens eine Eigenschaft und/oder weitere Eigenschaft solange verändert wird, bis der Wert einer Zielgröße oder eine aus Zielgrößen gebildete Zielfunktion oder eine Wahrscheinlichkeit eines Werts oder eine Wahrscheinlichkeitsverteilung einer Zielgröße oder eine Verteilungsfunktion der Zielgröße auf einem Optimum, insbesondere absoluten Optimum, liegt, wobei vorzugsweise die übrigen Eigenschaften festgelegt sind.

13. Computer-gestütztes Verfahren zum Trainieren eines Transformationsmodells (TM), insbesondere eines künstlichen neuronalen Netzes (KNN), zur Analyse einer Robustheit einer Fahrzeuggattung, deren Fahrzeuge eine Vielzahl an Komponenten aufweisen, folgende Arbeitsschritte aufweisend:

Erfassen von Konfigurationen einer Vielzahl von Fahrzeugen der Fahrzeuggattung, welche jeweils durch wenigstens eine Eigenschaft wenigstens einer Komponente des Fahrzeugs charakterisiert sind;
Simulieren von Betriebsverhalten der Vielzahl von Fahrzeugen mit jeweils verschiedener Konfiguration mittels eines Fahrzeugmodells (FM) der Fahrzeuggattung, wobei jede Konfiguration wenigstens eine Eigenschaft einer Komponente wenigstens eines Fahrzeugs der Fahrzeuggattung charakterisiert; und
Einlesen der Konfigurationen und der Ergebnisse des simulierten Betriebsverhaltens in eine Ausgleichsrechnung, welche die Grundlage für das Transformationsmodell (TM) bildet.

14. Computerprogramm, das Anweisungen umfasst, welche, wenn sie von einem Computer ausgeführt werden, diesen dazu veranlassen, die Schritte eines Verfahrens gemäß einem der Ansprüche 1 bis 13 auszuführen.

15. Computer-lesbares Medium, auf dem ein Computerprogramm nach Anspruch 14 gespeichert ist.

16. System (10) zur Analyse einer Robustheit einer Vielzahl von Fahrzeugen einer Fahrzeuggattung, welche eine Vielzahl an Komponenten aufweisen, folgende Arbeitsschritte aufweisend:

Mittel (11) zum Erfassen von Konfigurationen der Vielzahl von Fahrzeugen, welche durch wenigstens eine Eigenschaft wenigstens einer Komponente der Fahrzeuge charakterisiert sind;
Mittel (12) zum Bestimmen jeweils eines Werts einer Zielgröße in Bezug auf die Robustheit der Vielzahl von Fahrzeugen mittels eines Transfor-mationsmodells (TM), welches eine Zuord-nungsvorschrift $\left(f(\mathbb{X}^k)\right)$ zwischen Konfigurationen der Vielzahl von Fahrzeugen und der einen Zielgröße aufweist, wobei das Transformationsmodell (TM) auf einer Ausgleichsrechnung bezüglich Simulationergebnissen beruht, welche aus einer Betriebsverhalten-Simulation einer Vielzahl von Fahrzeugen der Fahrzeuggattung mit jeweils verschiedenen Konfigurationen mittels eines Fahrzeugmodells (FM) der Fahrzeuggattung resultieren; und
eine Schnittstelle (13) zum Ausgeben der Werte.

17. System (20) zur Analyse einer Robustheit eines Fahrzeugs einer Fahrzeuggattung, welches eine Vielzahl an Komponenten aufweist, folgende Arbeitsschritte aufweisend:

Mittel (21) zum Erfassen von Konfigurationen einer Vielzahl von Fahrzeugen der Fahrzeuggattung, welche jeweils durch wenigstens eine Eigenschaft wenigstens einer Komponente des Fahrzeugs charakterisiert sind;
Mittel (21) zum Simulieren von Betriebsverhalten der Vielzahl von Fahrzeugen mit jeweils ver-schiedener Konfiguration mittels eines Fahr-zeugmodells (FM) der Fahrzeuggattung, wobei jede Konfiguration wenigstens eine Eigenschaft einer Komponente wenigstens eines Fahrzeugs der Fahrzeuggattung charakterisiert;
Mittel (22) zum Durchführen einer Ausgleichsrechnung auf der Grundlage des simulierten Betriebsverhaltens der Vielzahl von Fahrzeugen; und

Mittel (23) zum Anwenden eines Transformationsmodells (TM) auf der Grundlage der Aus-gleichsrechnung, wobei das Transformations-modell (TM) eine Zuordnungsvorschrift $\left(f(\mathbb{X}^k)\right)$ zwischen Konfigurationen und wenigstens einer Zielgröße umfasst, wobei das Transformationsmodell (TM) eingerichtet ist, auf der Grundlage von Konfigurationen der Fahrzeuggattung einen Wert einer Zielgröße in Bezug auf die Robustheit der Fahrzeuggattung auszugeben.

$$F^{1*\cdots*k}$$

$$F'^{1*\cdots*k}$$

$$F''^{1*\cdots*k}$$

101

$\underline{\mathbb{X}^k}$

$\underline{\mathbb{X}^k}$

$\underline{\mathbb{X}^k}$

$\underline{\mathbb{X}^k}$

102

12

$\dfrac{f(\mathbb{X}_k)}{\underline{103}}$

TM

10   11/13   104

106

**Fehler-Code-Aktivierung**

Defekt

Kein
Defekt

0%   50%   100%

$\underline{105}$

Fig. 1

Fig. 2

Fig. 3

Fig. 4

Fig. 5

Fig. 7

Fig. 6

**CoP: Weniger exakter NOx Sensor**

Fig. 8

**CoP: Exakterer NOx Sensor**

Fig. 9

Europäisches
Patentamt

European
Patent Office

Office européen
des brevets

**EUROPÄISCHER RECHERCHENBERICHT**

Nummer der Anmeldung

EP 18 16 5403

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | BITTERMANN A ET AL: "Emissionsauslegung des dieselmotorischen Fahrzeugantriebs mittels DoE und Simulationsrechnung", MTZ - MOTORTECHNISCHE ZEITSCHRIFT, SPRINGER, Bd. 65, Nr. 6, 1. Juni 2004 (2004-06-01), Seiten 466-474, XP001519192, ISSN: 0024-8525 * das ganze Dokument * ----- | 1-17 | INV. G06Q10/06 G06Q10/00 |
| X,D | US 2003/009317 A1 (DHIR ANIL KUMAR [US] ET AL) 9. Januar 2003 (2003-01-09) * Absätze [0013] - [0022] * ----- | 1-17 | |
| A | PIFFL MARTIN ET AL: "The depth-design: An efficient generation of high dimensional computer experiments", JOURNAL OF STATISTICAL PLANNING AND INFERENCE, Bd. 164, 2015, Seiten 10-26, XP029156304, ISSN: 0378-3758, DOI: 10.1016/J.JSPI.2015.03.002 * das ganze Dokument * ----- | 1-17 | RECHERCHIERTE SACHGEBIETE (IPC) G06Q |

Der vorliegende Recherchenbericht wurde für alle Patentansprüche erstellt

| Recherchenort | Abschlußdatum der Recherche | Prüfer |
|---|---|---|
| München | 14. Mai 2018 | Breidenich, Markus |

**ANHANG ZUM EUROPÄISCHEN RECHERCHENBERICHT**
**ÜBER DIE EUROPÄISCHE PATENTANMELDUNG NR.**

EP 18 16 5403

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-05-2018

| Im Recherchenbericht angeführtes Patentdokument | Datum der Veröffentlichung | Mitglied(er) der Patentfamilie | Datum der Veröffentlichung |
|---|---|---|---|
| US 2003009317 A1 | 09-01-2003 | KEINE | |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3038026 A1

- US 20030009317 A1

**In der Beschreibung aufgeführte Nicht-Patentliteratur**

- **JONES ; NACHTSHEIM.** *Journal of Quality Technology,* 2011, vol. 43, 1-15